(19) **Europäisches Patentamt / European Patent Office / Office européen des brevets**

(11) **EP 4 586 487 A1**

(12) **EUROPEAN PATENT APPLICATION**
published in accordance with Art. 153(4) EPC

(43) Date of publication:
16.07.2025  Bulletin 2025/29

(21) Application number: 23862685.7

(22) Date of filing: 06.03.2023

(51) International Patent Classification (IPC):
$H02M\ 7/48^{(2007.01)}$  $H02M\ 1/08^{(2006.01)}$
$H03F\ 3/217^{(2006.01)}$  $H03K\ 17/687^{(2006.01)}$
$H05H\ 1/46^{(2006.01)}$

(52) Cooperative Patent Classification (CPC):
H02M 1/08; H02M 7/48; H03F 1/42; H03F 3/20;
H03F 3/217; H03K 17/687; H05H 1/46

(86) International application number:
PCT/JP2023/008248

(87) International publication number:
WO 2024/053135 (14.03.2024 Gazette 2024/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority:  08.09.2022  JP 2022142965

(71) Applicant: Kyosan Electric Mfg. Co., Ltd.
Tsurumi-ku, Yokohama-shi
Kanagawa 230-0031 (JP)

(72) Inventors:
• KUNITAMA Hiroshi
Yokohama-shi, Kanagawa 230-0031 (JP)
• YOSHIDA Takuya
Yokohama-shi, Kanagawa 230-0031 (JP)

(74) Representative: Hoffmann Eitle
Patent- und Rechtsanwälte PartmbB
Arabellastraße 30
81925 München (DE)

(54) **RADIO-FREQUENCY POWER SUPPLY DEVICE**

(57)  The radio-frequency power supply device of the present invention comprises: a radio-frequency amplification unit that carries out radio-frequency amplification by the switching operation of amplifying elements; and a gate drive unit that inputs a gate signal to the gate terminals of the amplifying elements in the radio-frequency amplification unit to drive the amplifying elements. The amplifying elements in the radio-frequency amplification unit are LDMOSFETs, and the switching elements in the gate drive unit are GaNFETs. By utilizing LDMOSFETs as the amplifying elements, a high-output/high-frequency radio-frequency is output, and by utilizing GaNFETs as the switching elements, individual differences in propagation delay in the switching elements are reduced, and the fluctuation in the dead time DT and pulse width $T_{on}$ of the gate signal for carrying out PWM control are suppressed to improve accuracy and reproducibility, to improve high-speed response characteristics, and to suppress high-frequency resonance.

EP 4 586 487 A1

**FIG. 1**

**Description**

[TECHNICAL FIELD]

The present invention relates to a radio-frequency power supply device that drives amplifying elements in a switching mode to output a radio frequency.

[BACKGROUND ART]

Radio-frequency power supply devices include a radio-frequency amplification unit configured to output a radio-frequency wave by amplifying power of radio-frequency with amplifying elements, and a gate drive unit for applying drive signals to gate terminals of the amplifying elements of the radio-frequency amplification unit.

(Radio-Frequency Amplification Unit)

There are MOSFETs known as amplifying elements for a radio-frequency amplification unit of a radio-frequency power supply device. Furthermore, there are two types of MOSFET known as a vertical double-diffused MOSFET (VDMOSFET) and a lateral double-diffused MOSFET (LDMOSFET).

The vertical double-diffused MOSFETs (VDMOSFETs) are used in AC-DC switching power supplies and inverters that are operated by switching according to their characteristics of high voltage resistance and large currents. The switching operation is typically limited between several tens of kHz to several tens of MHz. At a higher frequency, it is necessary to consider losses caused by ON resistance due to the characteristics of the elements.

By contrast, the lateral double-diffused MOSFETs (LDMOSFETs) have a drawback of difficulty in achieving high voltage resistance and low ON resistance, but have characteristics of low output capacitance $C_{oss}$ and small feedback capacitance $C_{rss}$. Since the LDMOSFETs have the low capacitance characteristics, they are suitable to be used as output control elements for a radio-frequency amplifier that requires radio-frequency characteristics enabling extremely high-speed operation.

The LDMOSFETs are typically applied to radio-frequency linear amplifiers, such as class-A amplifiers, class-B amplifiers, class-AB amplifiers, and class-C amplifiers, that are used in an active operation region, but are not applied for switching operations in a switching mode in class-D amplifiers, class-E amplifiers, class-F amplifiers and others.

(Gate Drive Unit)

When a general linear amplification is conducted, a gate drive unit of the radio-frequency power supply device uses a sinusoidal amplitude modulated signal as a gate signal, but not a rectangular-wave signal which is used for switching. In a case of switching an LDMOSFET with a conventional sinusoidal gate signal, a sinusoidal gate voltage $V_{gs}$ obtained by superimposing an AC voltage on a bias voltage is used. The bias voltage adjusts a reference level of the gate voltage $V_{gs}$, and the adjusted gate voltage $V_{gs}$ is compared with a threshold voltage $V_{th}$ to thereby determine a dead time DT and a pulse width $T_{on}$.

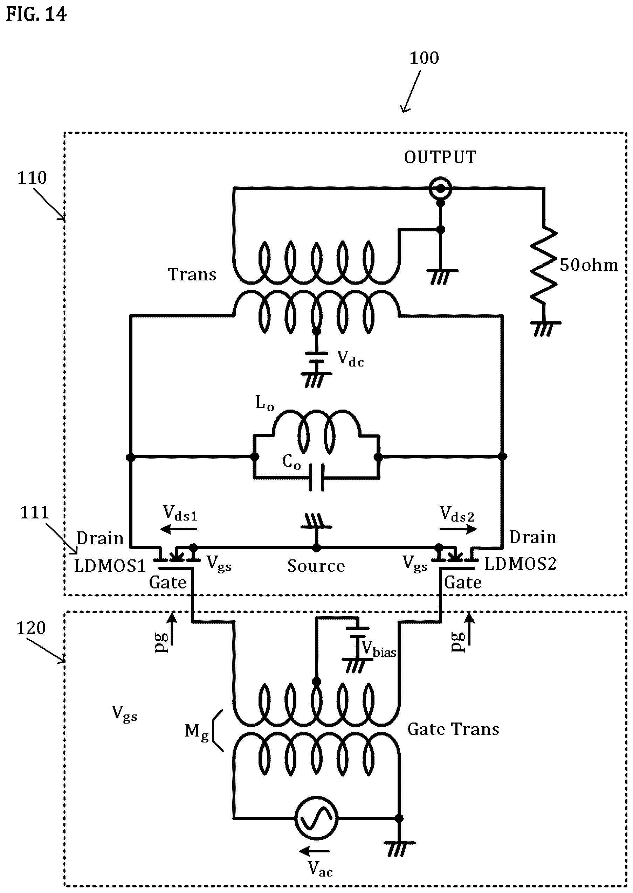

Figure 14 shows a configuration example of a conventional radio-frequency power supply device 100. The radio-frequency power supply device 100 includes a radio-frequency amplification unit 110 and a gate drive unit 120. The radio-frequency amplification unit 110 has an LDMOS 1 and an LDMOS 2 as LDMOSFET amplifying elements 111. The gate drive unit 120 is configured to apply gate signals to gate terminals respectively of the LDMOS 1 and the LDMOS 2. The LDMOS 1 and the LDMOS 2 conduct switching operations in response to the gate signals.

A gate drive circuit superimposes a sinusoidal gate voltage $V_{gs}$ obtained from an AC voltage $V_{ac}$ of an AC power supply on a bias voltage $V_{bias}$ and applies the resultant voltage to the gate terminals of the LDMOS 1 and the LDMOS 2. The gate voltage $V_{gs}$ is applied from the AC power supply to the gates of the LDMOS 1 and the LDMOS 2 via a mutual inductance $M_g$ of a gate transformer, there is a problem that a phenomenon of abnormal oscillation occurs in the LDMOSFETs during an OFF interval.

(Output Requirements of Radio-Frequency Signal)

In general, since the radio-frequency power supply device operative in a switching mode is configured to output a radio-frequency signal, the radio-frequency amplification unit has the following requirements (a) and (b) and the gate drive unit has the following requirement (c):

    (a) switching operation of amplifying elements;
    (b) high-speed/radio-frequency operation characteristics of amplifying elements; and
    (c) PWM control on amplifying elements.

With respect to the requirements (a), (b) and (c) of the radio-frequency signal required of the radio-frequency power supply device, a VDMOSFET satisfies the requirement (a) to perform the switching operation on the amplifying element, but does not satisfy the requirement (b) about the high-speed/radio-frequency operation characteristics. In order to satisfy the requirement (b) of the high-speed/radio-frequency operation characteristics of the amplifying element, it is conceivable that the VDMOSFET is replaced with a LDMOSFET with low capacitance characteristics. However, the LDMOSFET does not satisfy the requirement (a) of the switching operation of the amplifying element in a case of using a linear amplifier that conducts the amplification by utilizing an active region, such as a class-A amplifier, a class-B amplifier or a class-C amplifier.

The LDMOSFET has a problem associated with the requirement (c) of the PWM control on the amplifying element, in addition to the requirement (a), because the switching operation using the sinusoidal gate voltage $V_{gs}$ in the gate drive unit has a problem that the adjustment accuracy and reproducibility of the dead time DT and a pulse width $T_{on}$ are unstable.

In driving the LDMOSFET, the dead time DT and the pulse width $T_{on}$ are determined according to the threshold voltage $V_{th}$ and the gate voltage $V_{gs}$ of the amplifying element in the switching operation using the sinusoidal gate voltage $V_{gs}$. Thus, the dead time DT and the pulse width $T_{on}$ are affected significantly by the relationship with the threshold voltage $V_{th}$. The adjustment accuracy and reproducibility of the dead time DT and the pulse width $T_{on}$ are unstable because the threshold voltage $V_{th}$ fluctuates depending on the characteristics of the elements that form the gate drive unit. It is therefore difficult to perform the PWM control with variable pulse width of the gate signal using a sinusoidal wave in the gate drive for driving the radio-frequency amplifying element.

As a configuration that satisfies the output requirements (a) and (b) of the radio-frequency amplification unit for a radio-frequency amplification unit that uses the above-described conventional VDMOSFET amplifying elements, an amplifier is suggested that drives the LDMOSFET amplifying elements in a switching region (saturated region) (see Patent Literature 1).

Furthermore, for the output requirement (c) of the gate drive unit, a power supply device that conducts the PWM control with rectangular-wave signals on the LDMOSFET amplifying elements is suggested (see Patent Literature 2).

[PRIOR ART DOCUMENT]

[PATENT LITERATURE]

    [Patent Literature 1] Japanese Patent Laid-Open Publication No. 2017-092915
    [Patent Literature 2] Japanese Patent Laid-Open Publication No. H08-140341

[SUMMARY OF THE INVENTION]

[PROBLEMS TO BE SOLVED BY THE INVENTION]

In the radio-frequency power supply device, with respect to the requirements of the radio-frequency amplification unit, namely (a) switching operation of amplifying elements and (b) high-speed/radio-frequency operation characteristics of amplifying elements, the LDMOSFETs are used as amplifying elements to be driven in the switching region (saturated region) as suggested in Patent Literature 1.

With respect to the requirement of the gate drive unit, (c) PWM control on amplifying elements, the PWM control with the rectangular-wave gate signals is carried out on the LDMOSFET amplifying elements as suggested in Patent Literature 2.

However, the gate drive unit for conducting the PWM control, which has been suggested, has a problem that the accuracy and reproducibility of the dead time DT and the pulse width $T_{on}$ of the gate voltage $V_{gs}$ of the rectangular wave are not adequate to operate the LDMOSFETs at high-speed/radio-frequency.

A radio-frequency power supply device that outputs 1 [kW] or more and high-output/high-frequency radio frequency in a frequency range of 27 [MHz] to 100 [MHz] requires high accuracy and reproducibility for the dead time DT and the pulse width $T_{on}$ of a rectangular-wave gate signal for the PWM control on a LDMOSFET amplifying element.

As to the gate drive unit suggested in Patent Literature 2, it is suggested to conduct the PWM control by using a rectangular-wave gate signal. However, PWM control IC is employed by using Bi-MOSs (bipolar MOSs) as switching elements forming the gate drive unit. In general, Si-MOSFETs have individual differences in propagation delay from a time that a gate receives a control signal by a gate to a time that a switching element turns on. For example, there are individual differences of 1 [ns] to several [ns] in the conventional Si-MOSFETs. Thus, in regard to the PWM control IC with the Bi-MOSs (bipolar MOSs), the individual differences in the propagation delay in the switching elements cause the fluctuations in the dead time DT and the pulse width $T_{on}$ of the gate signal to be applied to the gate terminal of each LDMOSFET in the radio-frequency amplification unit to conduct the PWM control, resulting in problems with accuracy and reproducibility.

In the radio-frequency power supply device that outputs 1 [kW] or more and high-output/high-frequency radio frequency in a frequency range of 27 [MHz] to 100 [MHz], the individual differences in the propagation delay are not acceptable to enable the PWM control. Patent Literature 2 does not provide any technical description about the PWM control at the high-output/high-frequency radio frequency.

Furthermore, in the radio-frequency power supply device that outputs the high-output/high-frequency radio frequency, the gate drive unit has problems of high-speed response characteristics, suppression of high-frequency resonance due to parasitic capacitance and wiring inductance and so on, in addition to the problem of the accuracy and the reproducibility of the dead time DT and the pulse width $T_{on}$ of the gate signal due to the individual differences in the propagation delay in the switching elements. Patent Literature 2 does not disclose these problems and technical means for solving these problems.

An object of the present invention is to solve the above-described conventional problems, and to improve the accuracy and the reproducibility in the gate drive unit of the radio-frequency power supply device that outputs the high-output/high-frequency radio frequency by reducing the individual differences in the propagation delay in the switching elements and preventing the fluctuations in the dead time DT and the pulse width $T_{on}$ of the gate signal used for conducting the PWM control.

Another object of the present invention is to enhance the high-speed response characteristics in the gate drive unit of the radio-frequency power supply device outputting the high-output/high-frequency radio frequency to thereby suppress the high-frequency resonance.

[MEANS FOR SOLVING THE PROBLEM]

A radio-frequency power supply device of the present invention includes a radio-frequency amplification unit and a gate drive unit. The radio-frequency amplification unit includes amplifying elements, and a switching operation of each amplifying element causes radio-frequency amplification, so as to put out radio-frequency output power. The gate drive unit includes switching elements, and a switching operation of each switching element causes a gate signal input to a gate terminal of each amplifying element of the radio-frequency amplification unit to thereby drive each amplifying element by the gate signal.

For the radio-frequency power supply device including the radio-frequency amplification unit and the gate drive unit, the present invention employs LDMOSFETs as amplifying elements of the radio-frequency amplification unit and GaNFETs as switching elements of the gate drive unit.

Each of the GaNFETs of the gate drive unit is configured to generate a rectangular-wave gate signal by the switching operation, and apply the generated gate signal to a gate terminal of the LDMOSFET of the radio-frequency amplification unit to conduct PWM control.

The LDMOSFETs are used as amplifying elements of the radio-frequency amplification unit to output a high-output/high-frequency radio frequency. In addition to that, the GaNFETs are used as switching elements of the gate drive unit to reduce individual differences in propagation delay in the switching elements, thereby preventing fluctuations in a dead time DT and a pulse width $T_{on}$ of the gate signal used for conducting the PWM control and thus improving accuracy and producibility.

(Configuration for suppressing high-frequency resonance)

In order to enable the radio-frequency amplification unit to output a high-output/high-frequency radio frequency, it is necessary to minimize the fluctuations in the dead time DT and the pulse width $T_{on}$ of the rectangular-wave gate signal which is applied to the gate terminals of the LDMOSFET amplifying elements. In particular, in a high frequency region between 27 [MHz] and 100 [MHz], it is strongly required to suppress oscillations that occur at rise and fall of a rectangular waveform and prevent the fluctuations in the dead time DT and the pulse width $T_{on}$ of the gate signal.

The present invention focuses on high-frequency resonance phenomenon that occurs in the vicinity of a switching element as an oscillation that occurs at the rise or fall of the rectangular waveform, and prevents the high-frequency resonance to suppresses disturbance of the rectangular waveform of the gate signal.

In the gate drive unit of the present invention, for an LC resonance between an output parasitic capacitance $C_{oss}\_GaN$ of a switching element and an inductance $L_2$ of wiring connected to a drain terminal of the switching element, a drain resistance ($R_d$) is connected to the drain terminal of the switching element to attenuate a resonant oscillation. The drain resistance ($R_d$) attenuates an oscillation caused by an LC circuit consisting of the output parasitic capacitance $C_{oss}\_GaN$ and the wiring inductance $L_2$. It suppresses distortions at the rise and fall of the rectangular waveform and prevents the fluctuations in the dead time DT and the pulse width Ton of the gate signal. The switching elements are usually required to have low resistance due to a requirement to conduct a highly efficient radio-frequency operation. However, the present invention suppresses the oscillation of the LC resonance by adding drain resistance ($R_d$) in a GaNFET with low resistance characteristics.

(Configuration for high response characteristics)

The radio-frequency power supply device of the present invention needs a high-frequency rectangular waveform gate signal to drive the amplifying elements of the radio-frequency amplification unit at a high frequency and by the PWM control. In order to conduct the PWM control using the high-frequency rectangular waveform gate signal, the gate drive unit of the invention has a configuration that can enhance the high-frequency response characteristics of the gate drive unit. In a case where the high-frequency response characteristics of the gate drive unit is not adequate, a phenomena occur at the rise and fall of the rectangular waveform of the gate signal, such as a phenomenon in which a time constant increases and rise time/fall time becomes longer compared to the pulse width of the rectangular wave signal, and a waveform distortion phenomenon caused by an oscillation phenomenon in which the waveform oscillates.

The present invention has the gate drive unit and radio-frequency amplification unit having characteristics for improving the high-frequency responsivity in the gate drive unit, i.e. (A) electrical characteristics of circuit elements and (B) arrangement of the circuit elements.

(A) Electrical characteristics of circuit element

(a) Total gate charge (total gate charge amount) $Q_g$

The electrical characteristics of the circuit elements include total gate charge (total gate charge amount) $Q_g$ of the switching elements which are active elements of the gate drive unit. The present invention determines an upper limit value of the total gate charge $Q_g$ according to a switching frequency $f_{sw}$ of the switching operation at the high frequency, and uses the switching element that has smaller total gate charge (total gate charge amount) $Q_g$ than the upper limit value. The limitation of the upper limit value of the total gate charge $Q_g$ of the switching elements can increase the speed of the switching operation at the switching frequency $f_{sw}$ within the frequency range of a radio-frequency output.

The total gate charge (total gate charge amount) is also called as gate input charge amount. In the following description, the term "total gate charge (total gate charge amount)" will be used.

(b) LC resonance circuit in gate drive unit

In the gate drive unit, a wiring inductance L and a parasitic capacitance C included in a switching element form an LC resonance circuit. In a case where a resonant frequency $f_o$ generated by the LC resonance circuit is within the frequency range of the switching frequency $f_{sw}$ for the switching operation, it causes a distortion of the waveform of the gate signal. The radio-frequency power supply device of the present invention imposes a limitation on the wiring inductance to achieve a resonance frequency of the LC resonance circuit higher than the switching frequency $f_{sw}$, thereby reducing the influence of the resonance phenomenon.

(b1) Limitation on wiring inductance

A wiring inductance $L_1$ is an inductance of wiring connecting a switching element to a drive logic IC that applies a drive signal to a gate terminal of the switching element, and forms an LC resonance circuit with a gate capacitance $C_{iss}\_GaN$ of the switching element. In a case where the resonant frequency $f_{o1}$ generated by the LC resonance circuit is within the frequency range of the switching frequency $f_{sw}$ for the switching operation, it causes a distortion of the waveform of the gate signal.

The upper limit value of the inductance value of the wiring inductance $L_1$ is set such that the resonant frequency $f_{o1}$ generated by the LC resonance is higher than the switching frequency $f_{sw}$ of the radio-frequency switching operation. The upper limit value of the wiring inductance $L_1$ is limited to reduce the inductance of the wiring, so that the resonant frequency $f_{o1}$ generated by the LC resonance becomes higher than the frequency range of the switching frequency $f_{sw}$ of the radio-frequency switching operation. Consequently, when the switching frequency $f_{sw}$ of the switching operation is within the frequency range of the radio-frequency switching operation, the generation of the LC resonance is reduced, and thus the waveform distortion phenomenon caused by resonant vibration is prevented, thereby improving the high-frequency responsivity. The length of the wiring is set such that the wiring inductance $L_1$ is equal to or lower than the upper limit value.

(b2) Limitation on wiring inductance $L_2$

A wiring inductance $L_2$ is an inductance of wiring between a switching element and a bypass capacitor connected to a drain terminal of the switching element. The wiring inductance $L_2$ forms an LC resonance circuit with the output parasitic capacitance $C_{oss}\_GaN$ of the switching element.

The bypass capacitor connected to the drain terminal reduces an AC impedance for a grounding potential (ground) of the wiring to prevent noise caused by the switching operation of the switching element from leaking into power supply line.

In a case where a resonant frequency $f_{o2}$ generated by the LC resonance circuit is within the range of the switching frequency $f_{sw}$ of the switching operation, it causes a distortion of the waveform of the gate signal.

The upper limit value of the inductance value of the wiring inductance $L_2$ is set such that the resonant frequency $f_{o2}$ generated by the LC resonance is higher than the switching frequency $f_{sw}$ of the switching operation. The length of the wiring is set such that the wiring inductance $L_2$ is equal to or lower than the upper limit value.

The upper limit value of the wiring inductance $L_2$ is limited to reduce the inductance of the wiring, so that the resonant frequency $f_{o2}$ generated by the LC resonance becomes higher than the range of the switching frequency $f_{sw}$ of the radio-frequency switching operation. Consequently, when the switching frequency $f_{sw}$ of the switching operation is within the frequency range of the radio-frequency switching operation, the occurrence of the LC resonance phenomenon is prevented, and thus the waveform distortion phenomenon caused by the resonant vibration is prevented, thereby improving the high frequency responsivity. The length of the wiring is set such that the wiring inductance $L_2$ is equal to or lower than the upper limit value.

(b3) Limitation on wiring inductance $L_3$

A wiring inductance $L_3$ is an inductance of wiring between a source terminal of a high-side switching element of the gate drive unit and a gate terminal of an amplifying element. The wiring inductance $L_3$ forms an LC resonance circuit with a gate capacitance $C_{iss}\_LD$ of the amplifying element.

In a case where a resonant frequency $f_{o3}$ generated by the LC resonance circuit is within the range of the switching frequency $f_{sw}$ of the switching operation, it causes a distortion of the waveform of the gate signal.

The present invention sets the upper limit value of the inductance value of the wiring inductance $L_3$ such that the resonant frequency $f_{o3}$ generated by the LC resonance is higher than the switching frequency $f_{sw}$ of the radio-frequency switching operation. The length of the wiring is set such that the wiring inductance $L_3$ is equal to or lower than the upper limit value.

The upper limit value of the wiring inductance $L_3$ is limited to reduce the inductance of the wiring, so that the resonant frequency $f_{o3}$ generated by the LC resonance becomes higher than the range of the switching frequency $f_{sw}$ of the radio-frequency switching operation. Consequently, when the switching frequency $f_{sw}$ of the switching operation is within the range of the radio-frequency switching operation, the occurrence of the LC resonance phenomenon is prevented, and thus the waveform distortion phenomenon caused by the resonant vibration is prevented, thereby improving the high frequency responsivity. The length of the wiring is set such that the wiring inductance $L_3$ is equal to or lower than the upper limit value.

(b4) Drain resistance ($R_{dh}$, $R_{dl}$)

(i) Protection circuit

Each LDMOSFET of the radio-frequency amplification unit has a built-in gate protection circuit to protect the gate. When the LDMOSFET is used in a saturation region, the gate protection circuit prevents a negative reverse bias voltage from being applied beyond an allowable gate voltage when a reverse voltage is applied. This protection circuit also has an allowable voltage range, and in a case where a negative voltage applied from the gate drive unit exceeds the allowable voltage range of the gate protection circuit, the gate protection circuit may be broken down.

The present invention has a configuration that keeps the negative voltage applied to the gate protection circuit within the allowable voltage range to prevent the gate protection circuit from being broken down.

Furthermore, the gate drive unit in the radio-frequency power supply device of the present invention includes:

(a) a high-side switching element and a low-side switching element, which are connected in series; and
(b) a series circuit consisting of a series resistance ($R_e$) and a Zener diode (ZD), which are connected in parallel to a DC power source ($V_{dd}$).

The series circuit consisting of the series resistance ($R_e$) and the Zener diode (ZD) is configured to:

(c) apply a voltage across both ends of the series resistance ($R_e$) as a drive voltage $V_H$ to the high-side switching element, and apply a voltage across both ends of the Zener diode (ZD) as a reverse bias voltage $V_L$ to the low-side switching element,
(d) set the drive voltage $V_H$ and the reverse bias voltage $V_L$ within the range of a rated voltage of the protection circuit built in the radio-frequency amplification unit.

(ii) Drain resistance ($R_{dh}$, $R_{dl}$)

In a case where resonant vibration causes oscillation in the gate voltage $V_{gs}$ when the gate of the LDMOSFET is reverse biased, the gate voltage $V_{gs}$ may exceed a peak inverse voltage in the gate protection circuit of the LDMOSFET. This resonant vibration is caused by a resonance phenomenon occurring between the output parasitic capacitance $C_{oss\_GaN}$ of the GaN-FET and the wiring inductance $L_2$ between the bypass capacitor and the GaNFET because ON resistance of the GaNFET is very small ranging from several ohms to tens of ohms.

In order to prevent the occurrence of the resonance phenomenon, the present invention inserts drain resistance ($R_{dh}$, $R_{dl}$) on the drain side of the GaNFET. As the drain resistance ($R_{dh}$, $R_{dl}$), a resistance value around 0.5 [ohm] to 2 [ohm] is used, by way of example.

(b5) Gate resistance ($R_g\_LD$) of amplifying element

One of the electrical characteristics of the radio-frequency amplification unit is gate resistance ($R_g\_LD$) that is connected to the gate terminal of each amplifying element.

Each switching element of the gate drive unit includes the series circuit consisting of the high-side switching element and the low-side switching element. The wiring inductance $L_3$ between a connection point of the high-side and low-side switching elements and the gate terminal of the amplifying element forms an LC resonance circuit together with the gate capacitance $C_{iss}\_LD$ of the amplifying element. The resonance phenomenon occurring in the LC resonance circuit causes a distortion in the waveform of the gate signal, such as ringing. The gate resistance ($R_g\_LD$) of the present invention attenuates the resonance produced by the LC resonance circuit.

(C) Circuit element arrangement

As the configurations that enhance the high-frequency responsivity of the gate drive unit, the present invention has the following first configuration to sixth configuration regarding arrangement of the circuit elements included in the gate drive unit. The first configuration and second configuration show an element arrangement for avoiding electrical unevenness with respect to a reference potential, the third configuration and fourth configuration show an element arrangement for enhancing heat dissipation of the circuit elements, and the fifth configuration and sixth configuration show an element arrangement for shortening a current loop path.

In the radio-frequency amplification unit and the gate drive circuit included in the radio-frequency amplification power supply device, the radio-frequency amplification unit is a push-pull circuit that connects the source terminals of two amplifying elements to ground, and the gate drive unit has two gate drive circuits that apply gate signals to the gate terminals of the two amplifying elements of the radio-frequency amplification unit.

(a) First configuration of circuit element arrangement

According to the first configuration of the circuit element arrangement, the two gate drive circuits are configured as push-pull circuits with the same circuit configuration, and the circuit elements having the same function that form the respective gate drive circuits are in axisymmetric arrangement at a position that is symmetrical and equidistant from a symmetrical axis which passes through a COM potential. With this axisymmetric arrangement, the circuit elements of the two gate drive circuits are placed in an electrically symmetrical position with the COM potential as reference potential.

The electrically symmetrical arrangement of the circuit elements reduces the deviation between two gate signals occurring depending on each deviation of the gate signals from the reference potential, such as the fluctuations in the dead time DT and the pulse width $T_{on}$ of the gate signals, and an out-of-sync condition between the gate signals.

(b) Second configuration of circuit element arrangement

The second configuration of the circuit element arrangement has radial arrangement in addition to the axisymmetric arrangement in the first configuration.

A series circuit is formed by connecting the gate resistance ($R_{g\_}GaN$) to the respective gate terminals of the high-side switching element and the low-side switching element included in each gate drive unit between the drive logic IC that applies a drive signal to each gate terminal. The series circuit consisting of the drive logic IC and the gate resistance ($Rg\_GaN$) is linearly arranged with respect to the gate terminal, and is also radially arranged with respect to each switching element. The radial arrangement allows each series circuit to have the same wiring length and electrical length. It can eliminate a difference in wiring inductances due to the difference in the wiring lengths and reduce a discrepancy of delay time or others due to the difference in the electrical lengths.

(c) Third configuration of circuit element arrangement

The third configuration of the circuit element placement cools down the circuit elements.

The gate drive unit includes active elements and passive elements. The passive elements, such as the bypass capacitor and the resistive element, are placed on a front layer with respect to a substrate and are cooled by air cooling. The active elements, such as GaNFETs, are placed on the back side with respect to the substrate and are cooled by a heat dissipation unit that is in contact via a conductive heat member.

According to the present invention, the active elements and the passive elements, which have different heating values, are placed on the opposite sides through the substrate. The passive elements with a small heating value are placed on the front layer with respect to the substrate so as to be cooled by air cooling, and the active elements with a large heating value are placed on the back side with respect to the substrate so as to be cooled forcibly by the heat dissipation unit. The heat dissipation unit can be a water-cooled plate or fin.

(d) Fourth configuration of circuit element arrangement

The fourth configuration of the circuit element arrangement relates to the thermal conduction and the wiring inductance reduction.

In each gate drive unit, the passive elements, such as the bypass capacitor and the resistive element, are configured such that a parallel number and a width of the mounted wiring pattern are equal to or wider than the widths of the bodies of the amplifying elements of the radio-frequency amplification unit in terms of their effective widths.

The effective widths for the thermal conduction and the wiring inductance reduction in the passive elements are determined based on the number and the width of the mounted wiring pattern of the parallel-placed passive elements. The effective widths are equal to or wider than the widths of the bodies of the amplifying elements of the radio-frequency amplification unit, so that it is reflected in improvement of thermal conductivity through the passive elements and low wiring inductance.

(e) Fifth configuration of circuit element arrangement

The fifth configuration of the circuit element arrangement relates to a current loop that flows between the gate drive unit and the radio-frequency amplification unit.

In the gate drive unit, a conductive shield gasket is arranged on the back side and directly below the gate resistance ($R_{g\_}LD$) on the front layer sandwiching the substrate. The conductive shield gasket is a ground potential (GND2) on the gate drive unit side. Correspondingly, a source voltage in each amplifying element in the radio-frequency amplification unit is a ground potential (GND1) on the radio-frequency amplification unit side. The ground potential (GND2) on the gate drive unit side is electrically connected to the ground potential (GND1) on the radio-frequency amplification unit side via the heat dissipation unit so as to form a current loop between the gate drive unit and the radio-frequency amplification unit.

(f) Sixth configuration of circuit element arrangement

The sixth configuration of the circuit element arrangement relates to a current loop that flows between the gate drive unit and the radio-frequency amplification unit.

In the gate drive unit, each switching element is arranged below the drain resistance ($R_d$) and the bypass capacitor sandwiching the substrate, and is electrically connected via a through hole formed in the substrate. With this arrangement, the circuit elements, such as the switching element, the drain resistance ($R_d$) and the bypass capacitor, can be closely arranged, thereby reducing the wiring inductance and shortening the electrical length of the current loop.

[EFFECT OF THE INVENTION]

As described above, the present invention can reduce the individual differences in the propagation delay in the switching elements in the gate drive unit of the radio-frequency power supply device that outputs the high-output/high-frequency radio frequency, and prevent the fluctuations in the dead time DT and the pulse width $T_{on}$ of the gate signal for conducting the PWM control to thereby improve the accuracy and the reproducibility. Furthermore, the present invention improves the high-speed response characteristics and suppresses the high-frequency resonance in the gate drive unit of the radio-frequency power supply device that outputs the high-output/high-frequency radio frequency.

[BRIEF DESCRIPTION OF THE DRAWINGS]

Figure 1 illustrates a configuration of a radio-frequency power supply device of the present invention;

Figure 2 illustrates an operation of a gate drive unit;

Figure 3 illustrates an operation of the gate drive unit;

Figure 4 illustrates an operation of the gate drive unit;

Figure 5 illustrates a wiring inductance of the gate drive unit;

Figure 6 illustrates protection by a gate protection circuit;

Figure 7 illustrates protection by the gate protection circuit;

Figure 8 illustrates arrangement of circuit elements;

Figure 9 illustrates arrangement of the circuit elements;

Figure 10 illustrates arrangement of the circuit elements;

Figure 11 illustrates arrangement of the circuit elements;

Figure 12 illustrates arrangement of the circuit elements;

Figure 13 illustrates arrangement of the circuit elements; and

Figure 14 illustrates a configuration example of a conventional radio-frequency power supply device.

[BEST MODE FOR CARRYING OUT THE INVENTION]

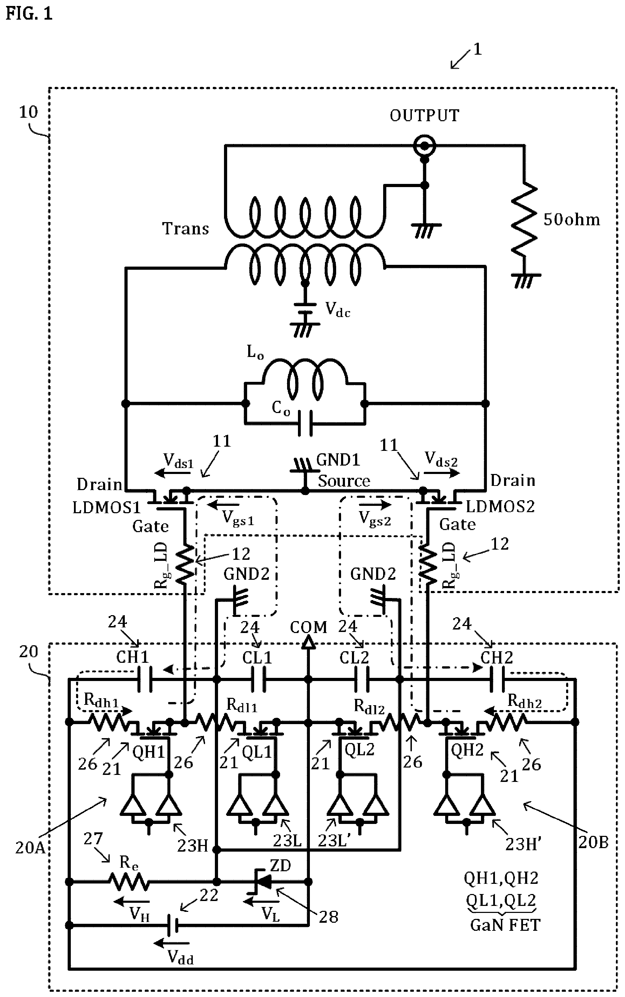

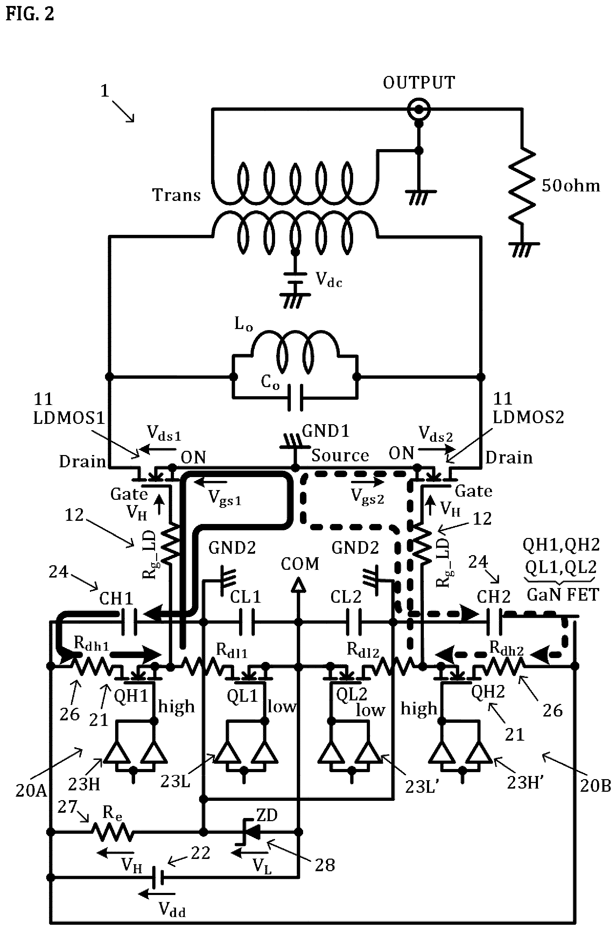

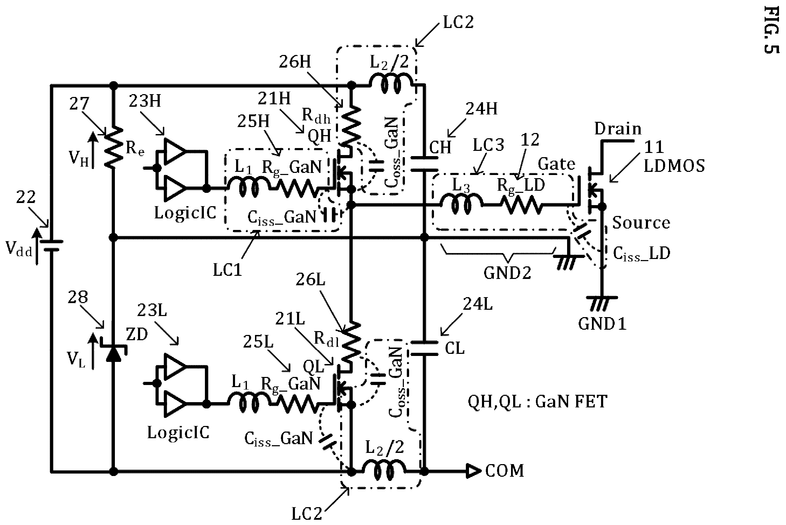

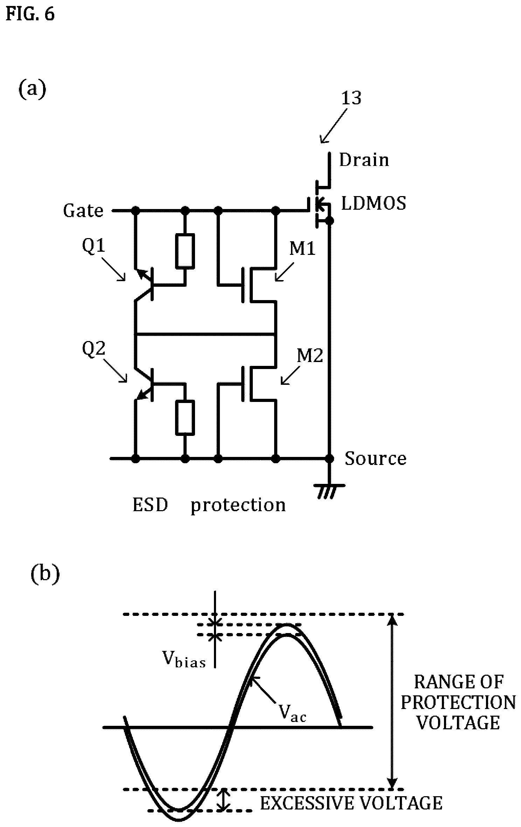

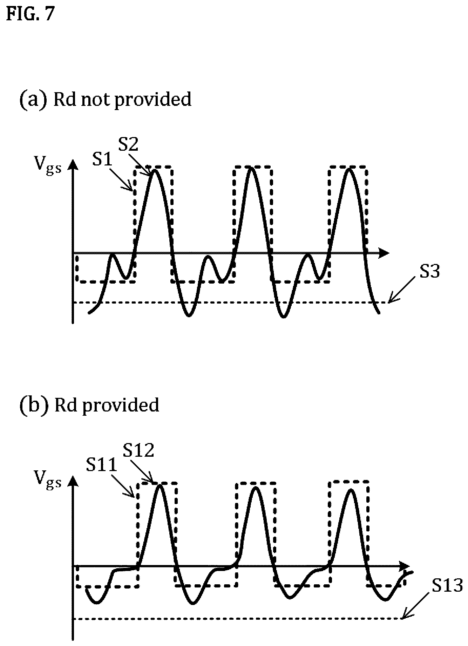

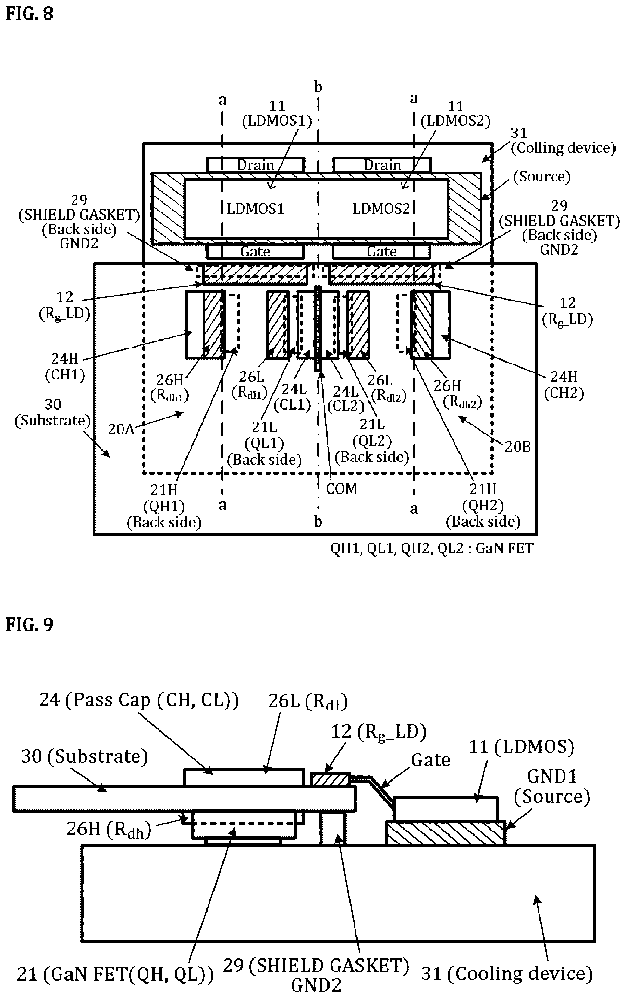

Now, a radio-frequency power supply device of the present invention will be described by referring to FIG. 1, operations of a gate drive unit will be described by referring to FIGS. 2 to 4, a wiring inductance of the gate drive unit will be described by referring to FIG. 5, protection by a gate protection circuit will be described by referring to FIGS. 6 and 7, and arrangement of circuit elements will be described by referring to FIGS. 8 to 13.

(A) Schematic Configuration of the Invention

Figure 1 illustrates a configuration of the radio-frequency power supply device of the present invention.
A radio-frequency power supply device 1 of the present invention includes a radio-frequency amplification unit 10 and a gate drive unit 20. The radio-frequency amplification unit 10 includes amplifying elements 11, and each of the amplifying elements 11 conducts a switching operation to amplify a radio frequency so as to put out radio-frequency output power.
The gate drive unit 20 includes switching elements 21. Each of the switching elements 21 conducts a switching operation to generate a rectangular-wave signal as a gate signal to input it to a gate terminal (Gate) of the amplifying element 11 in the radio-frequency amplification unit 10, thereby driving the amplifying element 11.
The radio-frequency amplification unit 10 employs lateral double-diffused MOSFETs (LDMOSFETs) as the amplifying elements 11, and the gate drive unit 20 employs GaNFETs as the switching elements 21. The GaNFETs of the gate drive unit 20 generate rectangular-wave gate signals by the switching operation, and apply the generated gate signals to gate terminals of the LDMOSFETs of the radio-frequency amplification unit 10.
The use of the LDMOSFETs as the amplifying elements 11 of the radio-frequency amplification unit 10 enables the output of high-output/high-frequency radio frequencies. In addition to that, the use of the GaNFETS as the switching elements 21 of the gate drive unit 20 enables the reduction of individual differences in propagation delay in the switching elements, and prevent fluctuations in a dead time DT and a pulse width $T_{on}$ of each gate signal for conducting PWM control so as to improve accuracy and producibility.

The radio-frequency power amplification unit 10 shown in FIG. 1 uses two amplifying elements 11 to form a push-pull configuration so as to increase the radio-frequency output.

(Configuration of Radio-Frequency Amplification Unit)

In the push-pull configuration, a source terminal of one of the amplifying elements 11 (LDMOS1) and a source terminal of the other of the amplifying elements 11 (LDMOS2) are grounded, and between drain terminals of the two amplifying elements 11, a parallel circuit consisting of an inductance $L_o$ and a capacitance $C_o$ and a primary coil of a transformer are connected in parallel. The primary coil has its midpoint connected with a DC voltage $V_{dc}$. The transformer has its secondary coil connected to an output end from which radio-frequency power is output to a load. It is to be noted that the above-described configuration of the inductance $L_o$ and the capacitance $C_o$ is an example, and is not limited thereto.

The amplifying elements 11 of the LDMOS1 and LDMOS2 output drain-source voltages $V_{ds1}$ and $V_{ds2}$ in opposite phases of each other, respectively, by the switching operations in the opposite phases of each other. The parallel circuit consisting of the inductance $L_o$ and the capacitance $C_o$ acts as a load impedance in an output circuit of the radio-frequency amplification unit 10 so that gains of the amplifying elements at a resonance frequency is maximized to increase the output of the drain-to-source voltages $V_{ds1}$ and $V_{ds2}$. The increased drain-to-source voltages $V_{ds1}$ and $V_{ds2}$ are output from the output end (OUTPUT) via the transformer to a load. FIG. 1 shows that a load of 50 [ohm] is connected to match the impedance to that of the radio-frequency amplification unit 10.

To the gate terminals of the amplifying elements 11 of the LDMOS1 and the LDMOS2, gate resistances 12 ($R_g$_LDs) are connected. Each gate resistance 12 ($R_g$_LD) attenuates resonant vibration in an LC resonance circuit that is formed by a gate capacity $C_{iss}$_LD of each amplifying element 11 and a wiring inductance $L_3$ between a source terminal of a high-side switching element 21 (QH1, QH2) of the gate drive unit 20 and the gate terminal of the amplifying element 11.

(Configuration of Gate Drive Unit)

In the push-pull configuration, the gate drive unit 20 includes a gate drive circuit 20A and a gate drive circuit 20B. The gate drive circuit 20A applies a gate signal to the gate terminal of the amplifying element 11 (LDMOS1), and the gate drive circuit 20B applies a gate signal to the gate terminal of the amplifying element 11 (LDMOS2). In FIG. 1, the gate drive circuit 20A is the circuit part shown on the left, and the gate drive circuit 20B is the circuit part shown on the right. The gate drive circuit 20A and the gate drive circuit 20B use a COM potential as a reference potential.

In the gate drive circuit 20A, the source terminal of the high-side switching element 21 (QH1) and a drain terminal of a low-side switching element 21 (QL1) are connected to a drain resistance ($R_{dl1}$), and the source terminal of the switching element 21 (QH1) is connected to the gate terminal of the amplifying element 11 (LDMOS1) through the gate resistance 12 ($R_g$_LD) of the radio-frequency amplification unit 10.

A drain terminal of the switching element 21 (QH1) is connected to a ground potential (GND2) through a drain resistance 26 ($R_{dh1}$) and a bypass capacitor 24 (CH1). Correspondingly, the source terminal of the switching element 21 (QL1) is connected to the COM potential, and is further connected to the ground potential (GND2) through the bypass capacitor 24.

The gate drive unit 20 has a power source that is formed by parallel connection of a DC power source 22 and a series circuit consisting of a series resistance 27 ($R_e$) and a Zener diode 28 (ZD), and the series circuit has its midpoint connected to the ground potential (GND2). In the DC power source 22, a DC power source voltage $V_{dd}$ is divided into a drive voltage $V_H$ for the series resistance 27 ($R_e$) and a reverse bias voltage $V_L$ for the Zener diode 28 (ZD), and the drive voltage $V_H$, which is positive, is applied on the drain side of the high-side switching element 21 (QH1) and the reverse bias voltage $V_L$, which is negative, is applied on the source terminal side of the low-side switching element 21 (QL1).

Configuration of gate drive circuit 20A:

When the switching element 21 (QH1) is ON, it applies the positive drive voltage $V_H$ as a gate signal to the gate terminal of the amplifying element 11 (LDMOS1). On the other hand, when the low-side switching element 21 (QL1) is ON, it applies the negative reverse bias voltage $V_L$ as a gate signal to the gate terminal of the amplifying element 11 (LDMOS1).

To the gate terminal of the switching element 21 (QH1), a control signal is applied from an output end of a drive logic IC 23H so as to control a switching operation of the switching element 21 (QH1). Furthermore, to the gate terminal of the switching element 21 (QL1), a control signal is applied from an output end of a drive logic IC 23L so as to control a switching operation of the switching element 21 (QL1). These control signals are basic signals for conducting PWM control on the radio-frequency amplification unit.

The drive logic ICs 23H and 23L have the parallel-connected configurations so that drive currents applied to the gate terminals of the switching elements 21 (QH1, QL1) can be increased.

Configuration of gate drive circuit 20B:

The gate drive circuit 20B has the configuration similar to that of the gate drive circuit 20A. In the gate drive circuit 20B, a source terminal of a high-side switching element 21 (QH2) and a low-side switching element 21 (QL2) are connected to a drain resistance ($R_{dl2}$), and the source terminal of the switching element 21 (QH2) is connected to the gate terminal of the amplifying element 11 (LDMOS2) through the gate resistance 12 ($R_g\_LD$) of the radio-frequency amplification unit 10.

A drain terminal of the switching element 21 (QH2) is connected to the ground potential (GND2) through a drain resistance 26 ($R_{dh2}$) and a bypass capacitor 24 (CH2). Correspondingly, a source terminal of the switching element 21 (QL2) is connected to the COM potential, and connected further to the ground potential (GND2) via a bypass capacitor 24 (CL2).

The positive drive voltage $V_H$ is applied on the drain side of the high-side switching element 21 (QH2), and the negative reverse bias voltage $V_L$ is applied on the source termina side of the low-side switching element 21 (QL2).

When the switching element 21 (QH2) is ON, it applies the positive drive voltage $V_H$ as a gate signal to the gate terminal of the amplifying element 11 (LDMOS2). On the other hand, when the low-side switching element 21 (QL2) is ON, it applies the negative reverse bias voltage $V_L$ as a gate signal to the gate terminal of the amplifying element 11 (LDMOS2).

To the gate terminal of the switching element 21 (QH2), a control signal is applied from an output end of a drive logic IC 23H' so as to control a switching operation of the switching element 21 (QH2). Furthermore, to the gate terminal of the switching element 21 (QL2), a control signal is applied from an output end of a drive logic IC 23L' so as to control a switching operation of the switching element 21 (QL2). These control signals are basic signals for conducting PWM control on the radio-frequency amplification unit.

The radio-frequency power supply device 1 shown in FIG. 1 is an example of the push-pull circuit, but can be applied to a single circuit. In the case of the single circuit, the circuit is composed of one of the amplifying elements 11 of the radio-frequency amplification unit 10 and either one of the gate drive circuits (20A or 20B) that drives the concerned amplifying element 11.

(B) Operation of Gate Drive Unit

The operation of the gate drive unit will be described by referring to FIGS. 2 to 4.

(a) Operation to turn on amplifying element

Figure 2 shows an operation of the gate drive unit 20 when one of the amplifying elements 11 of the radio-frequency amplification unit 10 is turned on. In FIG. 2, a solid line indicates an operating current in the gate drive circuit 20A, and a dashed line indicates an operating current in the gate drive circuit 20B. The circuits 20A and 20B are not turned on simultaneously, and thus they operate alternately with a dead time DT in between.

Operation of gate drive circuit 20A:

When the control signal causes the output of the drive logic IC 23H to be "high" and the output of the drive logic IC 23L to be "low" in the gate drive circuit 20A, the switching element 21 (QH1) is turned on and the switching element 21 (QL1) is turned off. During this operation, the switching element 21 (QH2) is turned off and the switching element 21 (QL2) is turned on in the gate drive circuit 20B.

The drain resistance 26 ($R_{dh1}$), which is series-connected to the drain terminal of the switching element 21 (QH1), is connected to a series resistance 27 ($R_e$), so that when the switching element 21 (QH1) is turned on, the drive voltage $V_H$ is applied from the source terminal of the switching element 21 (QH1) to the amplifying element 11 (LDMOS1) through the gate resistance 12 ($R_g\_LD$) to thereby turn the amplifying element 11 (LDMOS1) on.

When both the switching element 21 (QH1) and the amplifying element 11 (LDMOS1) are turned on, the source terminal of the switching element 21 (QH1) is connected to the ground potential (GND1) on the radio-frequency amplification unit 10 side through a path consisting of the gate resistance 12 ($R_g\_LD$), the gate terminal of the amplifying element 11 (LDMOS1) and the source terminal of the amplifying element 11 (LDMOS1). The drain terminal of the switching element 21 (QH1) is connected to the ground potential (GND2) on the gate drive unit 20 side through a path consisting of the drain resistance 26 ($R_{dh1}$) and the bypass capacitor 24 (CH1). These form a closed circuit between the radio-frequency amplification unit 10 and the gate drive unit 20 via the ground potentials (GND1, GND2), and thereby a current flows as indicated by a solid line in the figure.

Operation of gate drive circuit 20B:

When the control signal causes the output of the drive logic IC 23H' to be "high" and the output of the drive logic IC 23L' to be "low" in the gate drive circuit 20B, the switching element 21 (QH2) is turned on and the switching element 21 (QL2) is turned off. During this operation, the switching element 21 (QL1) is turned on and the switching element 21 (QH1) is turned off in the gate drive circuit 20A.

The drain resistance 26 ($R_{dh2}$), which is series-connected to the drain terminal of the switching element 21 (QH2), is connected to the series resistance 27 ($R_e$), so that when the switching element 21 (QH2) is turned on, the drive voltage $V_H$ is applied from the source terminal of the switching element 21 (QH2) to the amplifying element 11 (LDMOS2) through the gate resistance 12 ($R_g\_LD$) to thereby turn the amplifying element 11 (LDMOS2) on.

When both the switching element 21 (QH2) and the amplifying element 11 (LDMOS2) are turned on, the source terminal of the switching element 21 (QH2) is connected to the ground potential (GND1) on the radio-frequency amplification unit 10 side through a path consisting of the gate resistance 12 ($R_g\_LD$), the gate terminal of the amplifying element 11 (LDMOS2) and the source terminal of the amplifying element 11 (LDMOS2). The drain terminal of the switching element 21 (QH2) is connected to the ground potential (GND2) on the gate drive unit 20 side through a path consisting of the drain resistance 26 ($R_{dh2}$) and the bypass capacitor 24 (CH2). These form a closed circuit between the radio-frequency amplification unit 10 and the gate drive unit 20 via the ground potentials (GND1, GND2), and thereby a current flows as indicated by a dashed line in the figure.

(b) Operation to turn off amplifying element

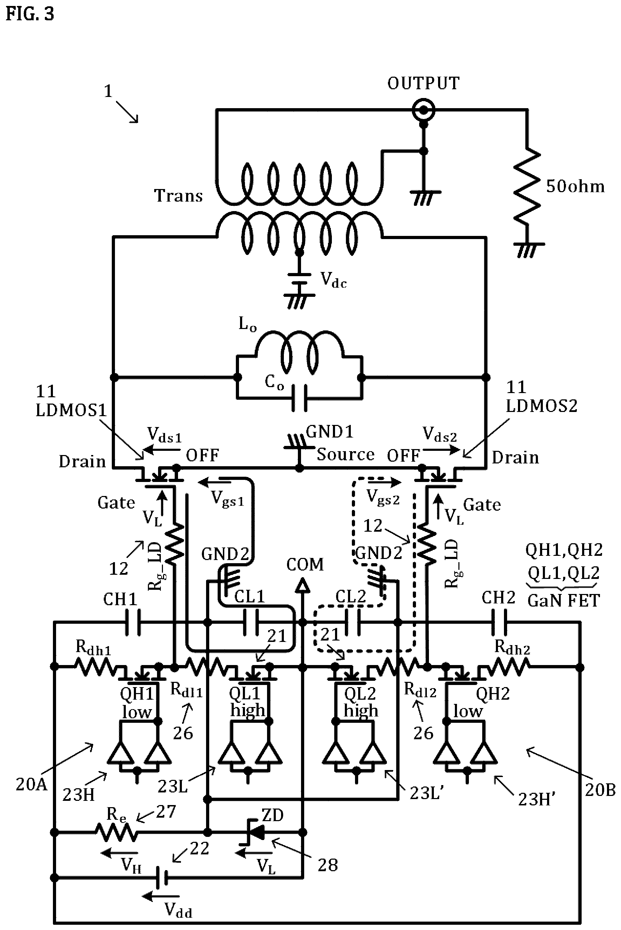

Figure 3 shows an operation of the gate drive unit 20 when one of the amplifying elements 11 of the radio-frequency amplification unit 10 is turned off. In FIG. 3, a solid arrow indicates a state of a voltage in the gate drive circuit 20A, and a dashed line indicates a state of a voltage in the gate drive circuit 20B. The circuits 20A and 20B may be turned off simultaneously during the dead time DT.

Operation of gate drive circuit 20A:

When the control signal causes the output of the drive logic IC 23L to be "high" and the output of the drive logic IC 23H to be "low" in the gate drive circuit 20A, the switching element 21 (QL1) is turned on and the switching element 21 (QH1) is turned off.

The negative voltage side of the Zener diode 28 (ZD) is connected to the source terminal of the switching element 21 (QL1), so that when the switching element 21 (QL1) is turned on, the reverse bias voltage $V_L$ is applied from the drain terminal of the switching element 21 (QL1) to the amplifying element 11 (LDMOS1) through the drain resistance 26 ($R_{dl1}$) and the gate resistance 12 ($R_g\_LD$) to thereby turn the amplifying element 11 (LDMOS1) off. The solid allow indicates the reverse bias voltage $V_L$ applied to the amplifying element 11 (LDMOS1). Consequently, a gate voltage $V_{gs1}$ is applied to the gate terminal of the amplifying element 11 (LDMOS1) through the path indicated by a solid line in FIG. 3.

Operation of gate drive circuit 20B:

In the gate drive circuit 20B, when the control signal causes the output from the drive logic IC 23L' to be "high" and the output from the drive logic IC 23H' to be "low", the switching element 21 (QL2) is turned on and the switching element 21 (QH2) is turned off.

The negative voltage side of the Zener diode 28 (ZD) is connected to the source terminal of the switching element 21 (QL2), so that when the switching element 21 (QL2) is turned on, the reverse bias voltage $V_L$ is applied from the drain terminal of the switching element 21 (QL2) to the amplifying element 11 (LDMOS2) through the drain resistance 26 ($R_{dl2}$) and the gate resistance 12 ($R_g\_LD$) to thereby turn the amplifying element 11 (LDMOS2) off. The dashed arrow indicates the reverse bias voltage $V_L$ which is applied to the amplifying element 11 (LDMOS2). Consequently, a gate voltage $V_{gs2}$ is applied to the gate terminal of the amplifying element 11 (LDMOS1) through the path indicated by the dashed line in FIG. 3.

(c) ON/OFF operation of switching elements

Figure 2 shows the LDMOS1 and LDMOS2 in the ON state, and FIG. 3 shows the LDMOS 1 and LDMOS2 in the OFF state. The radio-frequency amplification unit 10 turns on the LDMOS1 and the LDMOS2 in a complementary manner to thereby put out output power. In this complementary ON state, the LDMOS2 is OFF when the LDMOS1 is ON, and the LDMOS 1 is OFF when the LDMOS2 is ON.

The radio-frequency amplification unit 10 does not put out the output power when the LDMOS1 and the LDMOS2 are off. In addition to that, even when the amplifying elements 11 (LDMOS1, LDMOS2) are on, the radio-frequency amplification unit 10 cannot operate properly depending on the combination of the ON states of the switching elements 21 (QH1, QL1) included in the gate drive circuit 20A and the switching elements 21 (QH2, QL2) included in the gate drive circuit 20B.

For example, the combination that the switching element 21 (QH1) and the switching element 21 (QH2) are turned on simultaneously in FIG. 2, the radio-frequency amplification unit 10 does not put out the output power because it has the push-pull configuration. Furthermore, in the combination that the switching element 21 (QL1) and the switching element 21 (QL2) are turned off simultaneously in FIG. 3, the radio-frequency amplification unit 10 is in the OFF state and does not put out the output power.

When the switching elements 21 (QH1, QL1) included in the gate drive circuit 20A and the switching elements 21 (QH2, QL2) included in the gate drive circuit 20B are in the ON state, the radio-frequency amplification unit 10 operates in a state according to the following three combinations (c1), (c2) and (c3). The combinations (c1) and (c2) are when the output voltage is output from the radio-frequency amplification unit 10, and the combination (c3) is when the output voltage is a zero output from the radio-frequency amplification unit 10.

(c1) First combination

A first combination brings an operation state in which both the switching element 21 (QH1) of the gate drive circuit 20A and the switching element 21 (QL2) of the gate drive circuit 20B are turned on.

In the operation state according to the first combination, the amplifying element 11 (LDMOS1) is turned on when the switching element 21 (QH1) is turned on, and the amplifying element 11 (LDMOS2) is turned off when the switching element 21 (QL2) is turned on. This operation state causes a drain-to-source voltage $V_{ds1}$ of the amplifying element 11 (LDMOS1) to be output as an output voltage.

(c2) Second combination

A second combination brings an operation state in which both the switching element 21 (QH2) of the gate drive circuit 20B and the switching element 21 (QL1) of the gate drive circuit 20A are turned on.

In the operation state according to the second combination, the amplifying element 11 (LDMOS2) is turned on when the switching element 21 (QH2) is turned on, and the amplifying element 11 (LDMOS1) is turned off when the switching element 21 (QL1) is turned on. This operation state causes a drain-to-source voltage $V_{ds2}$ of the amplifying element 11 (LDMOS2) to be output as an output voltage.

(c3) Third combination

A third combination brings an operation state in which both the switching element 21 (QL1) of the gate drive circuit 20A and the switching element 21 (QL2) of the gate drive circuit 20B are turned on.

In the operation state according to the third combination, the amplifying element 11 (LDMOS1) is turned off when the switching element 21 (QL1) is turned on, and the amplifying element 11 (LDMOS2) is turned off when the switching element 21 (QL2) is turned on. In this operation state, neither of the amplifying element 11 (LDMOS1) nor the amplifying element 11 (LDMOS2) outputs the drain-to-source voltages $V_{ds1}$ and $V_{ds2}$.

(d) Operating current

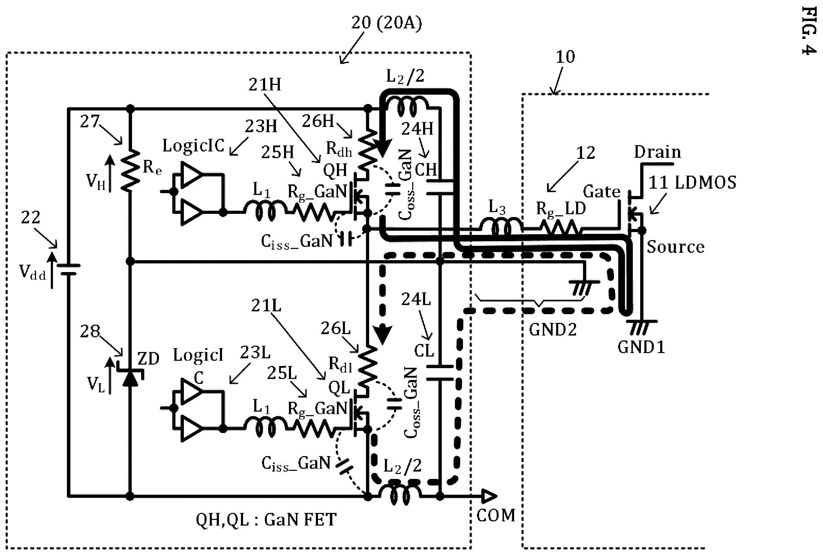

A description will be made about gate currents provided by the gate drive circuits 20A, 20B by referring to FIG. 4. FIG. 4 shows the gate drive circuit 20A only, in which the flow of a gate signal for driving the amplifying element 11 (LDMOS) is illustrated. FIG. 4 also shows wiring inductances $L_1$, $L_2$, $L_3$ as well as a gate capacitance (input parasitic capacitance) $C_{iss}\_GaN$ and an output parasitic capacitance $C_{oss}\_GaN$, which are parasitic capacitances of the GaNFETs of the switching elements 21 (QH, QL).

A solid arrow in the figure represents a gate current that turns on the amplifying element 11 (LDMOS), and a dashed arrow in the figure represents a voltage that turns off the amplifying element 11 (LDMOS).

The drive logic IC 23H is connected to the gate terminal of the switching element 21H (QH) via a gate resistance 25H ($R_g\_GaN$) so as to conduct a switching operation to turn on/off the switching element 21H (QH). The drive logic IC 23H employs a 5V COM logic, for instance. The voltage in the drive logic IC 23H is converted into a current by the gate resistance 25H ($R_g\_GaN$) and then injected into the gate terminal of the switching element 21H (QH).

The drain terminal of the switching element 21H (QH) is connected to the series resistance 27 ($R_e$) on its positive voltage side through the drain resistance 26H ($R_{dh}$), and the source terminal side of the switching element 21H (QH) is connected to the gate terminal of the amplifying element 11 (LDMOS) through the gate resistance 12 ($R_g\_LD$).

When the drive logic IC 23H is turned on with the drive voltage $V_H$ being applied, a conduction current of the switching element 21H (QH) is applied from the source terminal to the amplifying element 11 (LDMOS) through the gate resistance 12 ($R_g\_LD$), causing the switching operation to turn on the amplifying element 11 (LDMOS1).

The source terminal of the amplifying element 11 (LDMOS1) is connected to the ground potential (GND1) on the radio-frequency amplification unit 10 side and further connected to the ground potential (GND2) on the gate drive side, so that a current path is formed through which the current goes back to the drain terminal of the switching element 21H (QH) via the bypass capacitor 24H (CH).

The drive logic IC 23L is connected to the gate terminal of the switching element 21L (QL) through the gate resistance 25L ($R_g\_GaN$) to conduct the switching operation to turn on/off the switching element 21L (QL). The drive logic IC 23L employs, for example, the 5V COM logic. The voltage in the drive logic IC 23L is converted into a current by the gate resistance 25L ($R_g\_GaN$) and then injected into the gate terminal of the switching element 21L (QL).

The source terminal of the switching element 21L (QL) is connected on the negative voltage side of the Zener diode 28 (ZD), and the drain terminal of the switching element 21L (QL) is connected to the source terminal of the switching element 21H (QH) through the drain resistance 26L ($R_{dl}$) and further connected to the gate terminal of the amplifying element 11 (LDMOS) through the gate resistance 12 ($R_g\_LD$).

When the drive logic IC 23L is turned on with the reverse bias voltage $V_L$ being applied, the switching element 21L (QL) is conducted to thereby apply the reverse bias $V_L$ from the drain terminal to the gate terminal of the amplifying element 11 (LDMOS) through the drain resistance 26L ($R_{dl}$) and the gate resistance 12 ($R_g\_LD$), causing the switching operation to turn off the amplifying element 11 (LDMOS).

The gate resistances 25H, 25L ($R_g\_GaNs$) determine the gate currents that charge total gate charges

$Q_g\_GaN$ of the switching elements 21 (QH, QL), and the gate resistance 12 ($R_g\_LD$) determines the gate current that charges the total gate charge $Q_g\_LD$ of the amplifying element 11 (LDMOS).

The bypass capacitors 24 (CH, CL) reduce AC impedances for the ground potentials of the wiring to prevent noise in the switching elements from leaking into a power supply line.

(C) Electric characteristics of gate drive unit

A description will be made about improvement of the high-speed response characteristics due to electric characteristics in the gate drive unit 20 and the radio-frequency amplification unit 10 by referring to FIG. 5. In the following, the total gate charge (total gate charge amount) $Q_g$, the electric characteristics in the gate drive unit 20 of the wiring inductances $L_1$, $L_2$, $L_3$, which form the LC resonance circuits, and the electric characteristics in the radio-frequency amplification unit 10 of the gate resistance ($R_g\_LD$) connected to the gate terminal of the amplifying element 11.

(a) Limitation on total gate charge (total gate charge amount) $Q_g$

One of the electric characteristics of the switching elements of the gate drive unit 20 is the total gate charge (total gate charge amount) $Q_g$. The total gate charge (total gate charge amount) $Q_g$ is also called gate input charge amount.

The radio-frequency power supply device of the present invention can enhance the speed of the switching operation at a switching frequency $f_{sw}$ within a frequency range of a radio-frequency output by limiting an upper limit value of the total gate charge $Q_g$ of each switching element.

The total gate charge (total gate charge amount) $Q_g$ is a charge amount to be injected into a gate required to drive a MOSFET. If the total gate charge $Q_g$ of the MOSFET is large, it takes a long time to charge a charge amount required to turn on the MOSFET, and the switching operation is slow down. In addition, a dedicated IC is required for driving. In contrast, if the total gate charge Qg is small, the gate can be driven by a general-purpose logic IC. Furthermore, the switching operation becomes faster, and the switching operation can be conducted at high frequency.

The present invention employs GaNFETs having small total gate charge $Q_g$ as switching elements of the gate drive circuit to reduce switching losses and enhance the speed of the switching operation.

For example, in a frequency range of 27 [MHz] to 100 [MHz], a time width $t_{sw}$ of one cycle of a rectangular-wave gate signal at a frequency of 100 [MHz] is 10 [ns]. In a case where a delay time $t_d$ at the rise and the fall of the rectangular waveform of the gate signal has a large proportion with respect to the time width of the one cycle, a waveform distortion becomes large. If the ratio of the delay time td to the time wide $t_{sw}$ of 10 [ns] of the one cycle is 1/10, a time for injecting a charge into the gate terminal needs to be 0.5 [ns].

In general, the total gate charge $Q_g$ is expressed by a product ($Q_g=I_g*t_{on}$) of a gate current $I_g$ and a turn-on time $t_{on}$ of the switching element. From this relationship, assuming that the gate current $I_g$ is 1 [A] and the turn-on time $t_{on}$ is 0.5 [ns] corresponding to the time required to inject the charge into the gate terminal, then the total gate charge (total gate charge amount) $Q_g$ is 5 [nC].

According to the above-described example, the use of the GaNFETs having the total gate charge $Q_g$ of 5 [nC] can obtain a gate signal in which the waveform distortion due to the delay time at the high frequency of 100 [MHz] is reduced, thereby driving the amplifying elements 11 to obtain a high-frequency output of 100 [MHz].

The gate signals to be applied to the gate terminals of the GaNFETs are supplied from the drive logic ICs. In this case, when an output current supplied from one of the drive logic ICs is small, multiple drive logic ICs are connected in parallel to obtain the current adequate to drive the GaNFETs. The fastest CMOS logic IC of 5 [V] at present is 175 [MHz], and thus it has sufficient frequency characteristics as a driver IC for driving the GaNFETs for 27 [MHz] to 100 [MHz].

(b) LC resonance circuit of gate drive unit

In the gate drive unit 20, the wiring inductance L and the parasitic capacitance C included in each switching element form an LC resonance circuit. In a case where a resonance frequency $f_o$ of the LC resonance circuit is within the range of the switching frequency $f_{sw}$ of the switching operation, it causes the waveform distortion (attenuation) in the waveform of the gate signal. The radio-frequency power supply device of the present invention limits the upper limit of an inductance value of the wiring inductance so that the occurrence of the resonance phenomenon caused by the LC resonance circuit is prevented within the range of the switching frequency $f_{sw}$ of the switching operation.

A description will now be made about the limitations on the three wiring inductances $L_1$, $L_2$ and $L_3$ and about the drain resistances ($R_{dh}$, $R_{dl}$)

(b1) Limitation on wiring inductance $L_1$

One of the electric characteristics of the switching elements of the gate drive unit 20 is the wiring inductance $L_1$. The wiring inductance $L_1$ is an inductance of the wiring that connects the switching element and the drive logic IC which applies a drive signal to the gate terminal of this switching element. The wiring inductance $L_1$ forms an LC resonance circuit LC1 with a gate capacitance $C_{iss}\_GaN$ of the switching element. In a case where a resonance frequency $f_{o1}$ of the LC resonance circuit LC1 is within the range of the switching frequency $f_{sw}$ of the switching operation, it causes the occurrence of the waveform distortion (attenuation) in the waveform of the gate signal.

The present invention sets the upper limit value of the inductance value of the wiring inductance $L_1$ so that the resonance frequency $f_{o1}$ obtained by the LC resonance is higher than the switching frequency $f_{sw}$ of the switching operation. The length of the wiring is set such that the wiring inductance $L_1$ is equal to or lower than the upper limit value.

By limiting the upper limit value of the wiring inductance $L_1$ to reduce the wiring inductance, the resonance frequency $f_{o1}$ obtained by the LC resonance becomes higher than the range of the switching frequency $f_{sw}$ of the switching operation at the high frequency. It can prevent the occurrence of the LC resonance phenomenon when the switching frequency $f_{sw}$ of the switching operation is within the frequency range of the high-frequency switching operation, and thus the phenomenon of the waveform distortion (attenuation) caused by resonant vibration is prevented, thereby improving the high-frequency responsivity.

In the gate drive unit 20, the wiring inductance $L_1$ of the wiring between the gate terminal of the switching element and the drive logic IC varies depending on the wiring length. The LC resonance circuit is formed by the wiring inductance $L_1$ and the gate capacitance $C_{iss}\_GaN$ of the switching element.

In general, the resonance frequency $f_o$ of the LC resonance circuit is expressed by the following equation (1).
[Equation 1]

$$F_0 = (1/2\pi)\cdot\{1/(L\cdot C)^{1/2}\} \quad ..... (1)$$

In the LC resonance circuit LC1 formed by the parasitic capacitance C of the switching element of the GaNFET and the wiring inductance L, the inductance L is the wiring inductance $L_1$, and the capacitance C is the gate capacitance $C_{iss}\_GaN$. When the resonance frequency $f_o$ in Equation (1) is expressed as $f_{o1}$, the resonance frequency $f_{o1}$ is proportional to $\{1/(L\cdot C)^{1/2}\}$ and inversely proportional to $L^{1/2}$.

The upper limit value of the inductance value of the wiring inductance $L_1$ is set, then the inductance value of the wiring inductance $L_1$ is set to be equal to or lower than the upper limit value in the range of the switching frequency $f_{sw}$, and the resonance frequency $f_{o1}$ is set to be higher than the switching frequency $f_{sw}$ for conducting the switching operation. As a consequence, the range of the switching frequency $f_{sw}$ for driving the amplifying element 11 becomes lower than the resonance frequency $f_{o1}$, so that the occurrence of the LC resonance is prevented and thus the occurrence of the waveform distortion (attenuation) phenomenon caused by the resonant vibration is prevented, thereby improving the high-frequency responsivity.

In the configuration using GaNFETs as switching elements, since the gate capacitance $C_{iss}\_GaN$ of each GaNFET is typically around 200 [pF], the wiring inductance $L_1$ is 6 [nH] if the resonance frequency $f_{o1}$ is 140 [MHz], for instance. When the switching frequency $f_{sw}$ of the switching operation is 100 [MHz] which is the upper limit frequency in the frequency range, the wiring inductance $L_1$ at which the resonance phenomenon occurs is 12 [nH]. However, since the upper limit of the wiring inductance $L_1$ is limited to 6 [nH], the resonance phenomenon does not occur at the switching frequency $f_{sw}$.

As described above, by limiting the wiring inductance $L_1$ to 6 [nH] or lower, the occurrence of the resonant vibration is prevented when the amplifying element 11 is driven by the gate signal of 140 [MHz] or lower, and a rectangular-wave high-frequency output with a low distortion can be obtained in the frequency range between 27 [MHz] and 100 [MHz]. Since there is a positive correlation between the wiring inductance L and the wiring length, the wiring length of the wiring inductance $L_1$ is set to be shorter than a wiring length corresponding to the upper limit value.

(b2) Limitation on wiring inductance $L_2$

One of the electric characteristics of the switching elements of the gate drive unit 20 is the wiring inductance $L_2$. The wiring inductance $L_2$ is included in the wiring between each switching element and the bypass capacitor connected to the drain terminal of this switching element. The wiring inductance $L_2$ forms an LC resonance circuit LC2 with the output parasitic capacitance $C_{oss}\_GaN$ of the switching element.

The bypass capacitor connected to the drain terminal reduces an AC impedance for the ground potential of the wiring to prevent noise caused by the switching operation of the switching element from leaking into a power supply line.

In a case where the resonance frequency $f_{o2}$ of the LC resonance circuit LC2 is within the range of the switching frequency $f_{sw}$ of the switching operation, it causes the waveform distortion (attenuation) in the waveform of the gate signal applied to the LDMOS.

The present invention sets the upper limit value of the inductance value of the wiring inductance $L_2$ so that the resonance frequency $f_{o2}$ due to the LC resonance becomes higher than the switching frequency $f_{sw}$ of the switching operation. The length of the wiring is set such that the wiring inductance $L_2$ is equal to or lower than the upper limit value.

By limiting the upper limit value of the wiring inductance $L_2$, the resonance frequency $f_{o2}$ due to the LC resonance becomes higher than the range of the switching frequency $f_{sw}$ of the switching operation at high frequency. Consequently, the occurrence of the LC resonance phenomenon is prevented when the switching frequency $f_{sw}$ of the switching operation is within the frequency range of the switching operation at high frequency, and thus the occurrence of the waveform distortion (attenuation) caused by the resonant vibration is prevented, thereby improving the high-frequency responsivity.

In the gate drive unit 20, the wiring inductance $L_2$ of the wiring between the drain terminal of the switching element and the bypass capacitor connected to the drain terminal of this switching element varies depending on the wiring length. The LC resonance circuit LC2 is formed by the wiring inductance $L_2$ and the output parasitic capacitance $C_{oss}$\_GaN of the switching element.

In general, the resonance frequency $f_o$ of the LC resonance circuit is expressed by the above-described equation (1).

In the LC resonance circuit LC2 formed by the parasitic capacitance C of the switching element of the GaNFET and the wiring inductance L, the inductance L is the wiring inductance $L_2$, and the capacitance C is the output parasitic capacitance $C_{oss}$\_GaN. When the resonance frequency $f_o$ in Equation (1) is expressed as $f_{o2}$, the resonance frequency $f_{o2}$ is proportional to $\{1/(L \cdot C)^{1/2}\}$ and inversely proportional to $L^{1/2}$.

When setting the upper limit value of the inductance value of the wiring inductance $L_2$, the inductance value of the wiring inductance $L_2$ is set to be equal to or lower than the upper limit value in the range of the switching frequency $f_{sw}$, and the resonance frequency $f_{o2}$ is set to be higher than the switching frequency $f_{sw}$ for conducting the switching operation. Consequently, the range of the switching frequency $f_{sw}$ for driving the amplifying element 11 becomes lower than the resonance frequency $f_{o2}$, so that the occurrence of the LC resonance is prevented and thus the occurrence of the waveform distortion (attenuation) phenomenon caused by the resonant vibration is prevented, thereby improving the high-frequency responsivity.

In the configuration using GaNFETs as switching elements, provided that the output parasitic capacitance $C_{oss}$\_GaN of the GaNFET is around 300 [pF], the wiring inductance $L_2$ is 4 [nH] if the resonance frequency $f_{o2}$ is 140 [MHz], for instance. When the switching frequency $f_{sw}$ of the switching operation is 100 [MHz] which is the upper limit frequency in the frequency range, the wiring inductance $L_2$ at which the resonance phenomenon occurs is 8 [nH]. However, since the upper limit of the wiring inductance $L_2$ is limited to 4 [nH], the resonance phenomenon does not occur at the switching frequency $f_{sw}$.

As described above, by limiting the wiring inductance $L_2$ to 4 [nH] or lower, the occurrence of the resonant vibration is prevented when the amplifying element 11 is driven by the gate signal of 140 [MHz] or lower, and a rectangular-wave high-frequency output with a low distortion can be obtained in the frequency range between 27 [MHz] and 100 [MHz].

Since there is a positive correlation between the wiring inductance L and the wiring length, the wiring length of the wiring inductance $L_2$ is set to be shorter than a wiring length for the upper limit value.

The limitation of the wiring inductance $L_2$ is made by setting parallel numbers and widths of the mounted wiring patterns of the bypass capacitors 24H (CH), 24L (CL) and the drain resistances 26H ($R_{dh}$), 26L ($R_{dl}$) to be equal to or wider than widths of the bodies of the switching elements 21H, 21L (GaNFETs).

(b3) Limitation on wiring inductance $L_3$

One of the electric characteristics of the gate drive unit 20 and the radio-frequency amplification unit 10 is the wiring inductance $L_3$. The wiring inductance $L_3$ is included in the wiring between the source terminal of the high-side switching element of the gate drive unit 20 and the gate terminal of each amplifying element 11 of the radio-frequency amplification unit 10.

The wiring inductance $L_3$ forms an LC resonance circuit LC3 with the gate capacitance $C_{iss}$\_LD of the amplifying element 11. Since the source terminal of the high-side switching element is connected to the drain terminal of the low-side switching element, the LC resonance circuit LC3 is also connected to the drain terminal of the low-side switching element.

In a case where a resonance frequency $f_{o3}$ of the LC resonance circuit LC3 is within the range of the switching frequency $f_w$ of the switching operation, it causes the occurrence of the waveform distortion (attenuation) in the waveform of the gate signal.

The present invention sets the upper limit value of the inductance value of the wiring inductance $L_3$ such that the resonance frequency $f_{o3}$ due to the LC resonance is higher than the switching frequency $f_{sw}$ of the high-frequency switching operation. The length of the wiring is set such that the wiring inductance $L_3$ is equal to or lower than the upper limit value.

By limiting the upper limit value of the wiring inductance $L_3$ and thus reducing the wiring inductance, the resonance frequency $f_{o3}$ due to the LC resonance becomes higher than the range of the switching frequency $f_{sw}$ of the high-frequency switching operation. Consequently, the occurrence of the LC resonance phenomenon is prevented when the switching frequency $f_{sw}$ of the switching operation is within the frequency range of the high-frequency switching operation, and thus the occurrence of the waveform distortion (attenuation) caused by the resonant vibration is prevented, thereby improving the high-frequency responsivity.

The wiring inductance $L_3$ of the wiring between the source terminal of the high-side switching element of the gate drive unit 20 and the gate terminal of the amplifying element 11 varies depending on the wiring length. The LC resonance circuit LC3 is formed between the wiring inductance $L_3$ and the gate capacitance $C_{iss}$\_LD of the amplifying element 11.

In general, the resonance frequency $f_o$ of the LC

resonance circuit is expressed by the above-described equation (1).

In the LC resonance circuit LC3 formed by the parasitic capacitance C of the amplifying element 11 of the LDMOSFET and the wiring inductance L, the inductance L is the wiring inductance $L_3$, and capacitance C is the gate capacitance $C_{iss}$_LD. When the resonance frequency $f_o$ in Equation (1) is expressed as $f_{o3}$, the resonance frequency $f_{o3}$ is proportional to $\{1/(L \cdot C)^{1/2}\}$ and inversely proportional to $L^{1/2}$.

The upper limit value of the inductance value of the wiring inductance $L_3$ is set, then the inductance value of the wiring inductance $L_3$ is set to be equal to or lower than the upper limit value in the range of the switching frequency $f_{sw}$, and the resonance frequency $f_{o3}$ is set to be higher than the switching frequency $f_{sw}$ for conducting the switching operation. Since the range of the switching frequency $f_{sw}$ for driving the amplifying element 11 is lower than the resonance frequency $f_{o3}$, the occurrence of the LC resonance is prevented and the occurrence of the waveform distortion phenomenon caused by the resonant vibration is prevented, thereby improving the high-frequency responsivity.

In the configuration using LDMOSFETs as the amplifying elements 11, provided that the gate capacitance $C_{iss}$_LD of each LDMOSFET is 400 [pF], the wiring inductance $L_3$ is 3 [nH] if the resonance frequency $f_{o3}$ is 140 [MHz]. When the switching frequency $f_{sw}$ of the switching operation is 100 [MHz] which is the upper limit frequency in the frequency range, the wiring inductance $L_3$ at which the resonance phenomenon occurs is 6 [nH]. However, since the upper limit of the wiring inductance $L_2$ is limited to 3 [nH], the resonance phenomenon does not occur at the switching frequency $f_{sw}$.

As described above, by limiting the wiring inductance $L_3$ to 3 [nH] or lower, the occurrence of the resonant vibration is prevented when the amplifying element 11 is driven by the gate signal of 140 [MHz] or lower, and a rectangular-wave high-frequency output with a low distortion can be obtained in the frequency range between 27 [MHz] and 100 [MHz].

There is a positive correlation between the wiring inductance L and the wiring length. Thus, the wiring length is set to be shorter than a wiring length for the upper limit value of the wiring inductance $L_3$. The configuration having short wiring length includes an arrangement configuration in which the switching elements 21H, 21L (QH, QL), the bypass capacitors 24H, 24L (CH, CL), the gate resistance 12 ($R_g$_LD), and the drain resistance Rd ($R_{dh}$, $R_{dl}$) are arranged in immediate proximity to the gate terminals of the amplifying elements 11 (LDMOS1, LDMOS2), e.g. within 25 [mm], and a configuration in which the numbers of parallel connections and widths of the mounted wiring patterns of the gate resistances 12 ($R_g$_LD) of the amplifying elements 11 (LDMOS1, LDMOS2) are set to be equal to or greater than widths of electrodes of the gate resistances 12 ($R_g$_LD) of the amplifying elements 11 (LDMOS1, LDMOS2). Furthermore, as an arrangement configuration for a substrate 30, the ground potential (GND2) is arranged on the back side of the substrate 30 directly under the gate resistance 12 ($R_g$_LD) arranged on the front side of the substrate 30, and the substrate 30 is connected to the source terminal side of the amplifying elements 11 (LDMOS1, LDMOS2) using a conductive shield gasket 29 or like via cooling device 31 of the ground potential (GND1). The shield gasket 29 should be equal to or wider than the width of the gate terminals of the amplifying elements 11 (LDMOS1, LDMOS2). The reference numerals 29, 30 and 31 for shield gasket 29, the substrate 30 and the cooling device 31, respectively, are shown in FIGS. 8 to 10.

According to the above-described arrangement configuration, a current loop is formed by connecting the source terminals of the switching elements 21H, 21L (QH, QL) to the gate terminals of the amplifying elements (LDMOS1, LDMOS2) through the wiring inductance $L_3$ and the gate resistance 12 ($R_g$_LD), and further to the ground potential (GND1) and the ground potential (GND2) from the source terminals of the amplifying elements 11 (LDMOS1, LDMOS2), and the diameter of the current loop viewed from the cross-sectional direction shall be 10 [mm] or less. This loop can reduce the wiring inductance $L_3$. In this regard, a description will be made in the term of the current loop.

(b4) Drain resistances ($R_{dh}$, $R_{dl}$)

(i) Gate protection circuit

Each LDMOSFET of the radio-frequency amplification unit is provided with a gate protection circuit for protecting the gate. In using the LDMOSFET in a saturated region, when a reverse voltage is applied, the gate protection circuit prevents a negative reverse bias voltage exceeding an allowable voltage from being applied to the gate. As a gate protection circuit, there is a known circuit configuration that is incorporated in a radio-frequency amplification unit.

Figure 6(a) shows a circuit example of a gate protection circuit 13, and FIG. 6(b) shows a voltage range for protection in the gate protection circuit. The protection circuit is configured to protect semiconductor devices from electro static discharge (ESD) caused by externally generated static electricity.

In the circuit example shown in FIG. 6(a), the gate protection circuit 13 consists of first npn-type bipolar transistors Q1, Q2 with resistances connected to base terminals and second n-type MOS transistors M1, M2 in which gate terminals are connected to source terminals. The first bipolar transistors Q1, Q2 act as diodes that are biased in the reverse direction due to conductivity between a collector and an emitter caused by a leakage current between the collector and a base. The second MOS transistors M1, M2 act as diodes that are biased in the reverse direction due to parasitic diodes.

A series circuit consisting of the first bipolar transistor Q1 and the second MOS transistor M2 forms a first protection circuit when a positive voltage is applied to a Gate, and a series circuit consisting of the first bipolar transistor Q2 and the second MOS transistor M1 forms a second protection circuit when a negative voltage is applied to the Gate. The sum of a breakdown voltage in the first bipolar transistor Q1 and a breakdown voltage in the second MOS transistor M2 is a breakdown voltage in the gate protection circuit for a positive voltage, and the sum of a breakdown voltage in the first bipolar transistor Q2 and a breakdown voltage in the second MOS transistor M1 is a breakdown voltage in the gate protection circuit for a negative voltage.

The gate protection circuit has an allowable voltage range, and when a negative reverse voltage supplied from the gate drive unit to a reverse voltage application exceeds the allowable voltage range of the gate protection circuit, the gate protection circuit may be destroyed.

In Figure 6(b), in a case where an LDMOSFET with a gate protection circuit in a voltage range for protection of -6 [V] to +11 [V] is used in the saturated region, if the gate of the LDMOS is driven by a sinusoidal voltage $V_{ac}$ with an amplitude of $\pm 9$ V relative to zero potential, a negative voltage of -8 [V] is applied to the gate when the reverse voltage is applied even if a DC bias voltage $V_{bias}$ is set to 1 [V]. When an excess voltage beyond the voltage range for protection is applied to the gate protection circuit, the gate protection circuit may be destroyed.

A gate circuit using GaNFETs has similar problem, and if resonant vibration produces fluctuation in a gate voltage $V_{gs}$ when the LDMOSFET gate is reversely biased, the voltage may exceed a peak inverse voltage of the gate protection circuit for the LDMOSFET. The resonant vibration is caused by a resonance phenomenon that occurs between the output parasitic capacitance $C_{oss}\_GaN$ of the GaNFET and the wiring inductance $L_2$ between the GaNFET and the bypass capacitor because ON resistance of the GaNFET is very small (from a few ohm to several tens ohm).

(ii) Drain resistances ($R_{dh}$, $R_{dl}$)

In order to prevent the occurrence of the resonant phenomenon, the present invention inserts the drain resistances 26 ($R_{dh}$, $R_{dl}$) on the drain side of the GaNFET. A resistance value about 0.5 [ohm] to 2 [ohm] is used for the drain resistances 26 ($R_{dh}$, $R_{dl}$), by way of example.

In a gate drive circuit, which is typically used in a frequency band of 27 [MHz] or lower, Si-MOSFETs are generally used as switching elements, in which the ON resistance is relatively large at 0.5 [ohm] or more. Thus, the possibility of the occurrence of resonance phenomenon is low.

By contrast, in the case of using the GaNFETs to be driven by the rectangular gate signals in the frequency band of 27 [MHz] to 100 [MHz], the resonance between the wiring inductance $L_2$ and the output parasitic capacitance $C_{oss}\_GaN$ of the GaNFET is hardly attenuated because the ON resistance of the GaNFET is low. In order to attenuate the resonance, the present invention has the drain resistances ($R_{dh}$, $R_{dl}$)

Figure 7 shows the gate voltage $V_{gs}$ to be applied to the gate of the amplifying element 11 (LDMOS), in which FIG. 7(a) shows the gate voltage $V_{gs}$ with no drain resistances 26 ($R_{dh}$, $R_{dl}$) being provided, and FIG. 7(b) shows the gate voltage $V_{gs}$ with the drain resistances 26 ($R_{dh}$, $R_{dl}$) being provided. In FIGS. 7(a) and 7(b), a rectangular waveform marked with S1 indicated with a dashed line represents an ideal gate voltage $V_{gs}$, and a waveform marked with S2 indicated with a solid line schematically represents an actual signal waveform of the gate voltage $V_{gs}$. In addition to that, a dashed line marked with S3 indicates a peak inverse voltage of the gate protection circuit. It is to be noted that these waveform shapes are shown schematically and do not represent actual waveform shapes.

In the case where the drain resistances 26 ($R_{dh}$, $R_{dl}$) are not provided, the negative peak voltage of the gate voltage $V_{gs}$ exceeds the peak inverse voltage of the gate protection circuit, which causes destruction of the gate protection circuit. By contrast, in the case where the drain resistances 26 ($R_{dh}$, $R_{dl}$) are provided, the negative peak voltage of the gate voltage $V_{gs}$ does not exceed the peak inverse voltage of the gate protection circuit, so that the gate protection circuit is protected.

The configuration having the resistances connected in series on the source terminal side of the GaNFET can attenuate the resonance phenomenon. However, it is not preferable because it affects the gate side of the GaNFET.

(iii) Protection of gate protection circuit

The present invention has the configuration to keep the negative voltage applied to the gate protection circuit within the allowable voltage range to prevent the gate protection circuit from being destroyed. The drive voltage $V_H$ and the reverse bias voltage $V_L$ to be applied to the GaNFETs are set to be within a rated voltage of the gate protection circuit.

In the radio-frequency power supply device 1 of the present invention, the gate drive unit 20 includes as a power supply configuration the DC power source 22 ($V_{dd}$), and a series circuit connected in parallel to the DC power source 22 that consists of the series resistance 27 ($R_e$) and the Zener diode 28 (ZD).

The series circuit consisting of the series resistance 27 ($R_e$) and the Zener diode 28 (ZD) applies a voltage across the series resistance 27 ($R_e$) as the drive voltage $V_H$ to the high-side switching element 21 (QH), and applies a voltage across the Zener diode 28 (ZD) as the reverse bias voltage $V_L$ to the low-side switching element 21 (QL).

The drive voltage $V_H$ and the reverse bias voltage $V_L$ are set to be within the range of the rated voltage of the gate protection circuit incorporated in the radio-frequency amplification unit 10 to protect the gate protection circuit from the excessive voltage and further protect the gate of the amplifying element 11 (LDMOS).

Provided that the rate voltage of the gate protection circuit of the LDMOS is +11 [V]/-6 [V], the ranges of the drive voltage $V_H$ and the reverse bias voltage $V_L$ are set to

$$V_H = 6 \text{ to } 11 \text{ [V]}$$

$$V_L = 0.5 \text{ to } 6 \text{ [V]}$$

so that at most the voltage $V_{gs} = 11$ [V]/-6 [V] is applied to the gate of the LDMOS, thereby preventing the gate from being destroyed.

In the gate protection circuit, the negative voltage of the reverse bias voltage $V_L$ is continuously applied to the gate of the LDMOSFET in an OFF state, so that anomalous oscillation can be prevented even in an OFF interval of an ON/OFF pulse operation which is used in a semiconductor manufacturing apparatus.

(b5) Gate resistance ($R_g\_LD$) of amplifying element

One of the electric characteristics of the radio-frequency amplification unit 10 is the gate resistances ($R_g\_LD$s) connected to the gate terminals of the amplifying elements 11.

The switching elements of the gate drive unit 20 include the high-side switching element and the low-side switching element, which are connected in series to each other.

The wiring inductance $L_3$ between a connection point of the high-side and low-side switching elements and the gate terminal of the amplifying element 11 forms the LC resonance circuit LC3 with the gate capacitance $C_{iss}\_LD$ of the amplifying element 11. The resonance phenomenon of the LC resonance circuit LC3 causes the occurrence of the waveform distortion, such as ringing, of the waveform of the gate signal. The gate resistance ($R_g\_LD$) of the present invention attenuates the resonance due to the LC resonance circuit LC3.

The present invention connects the gate resistance ($R_g\_LD$) between the output end of the switching element 21 of the gate drive unit 20 and the gate terminal of the amplifying element 11 to attenuate the amplitude of the vibration due to the LC resonance circuit, thereby suppressing the ringing during the turn-on time $t_{on}$ at the rising edge of the gate signal.

By setting the gate resistance ($R_g\_LD$) to a predetermined value, the amplitude of the vibration due to the LC resonance circuit LC3 is attenuated, and thus the ringing is suppressed during the turn-on time at the rising edge of the gate signal.

(D) Arrangement of circuit elements

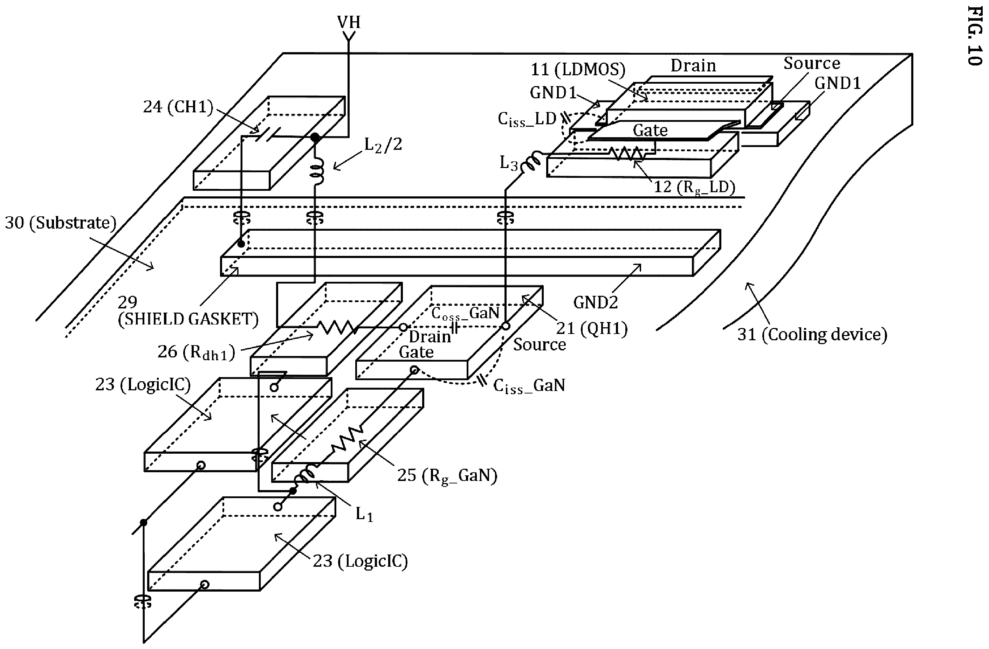

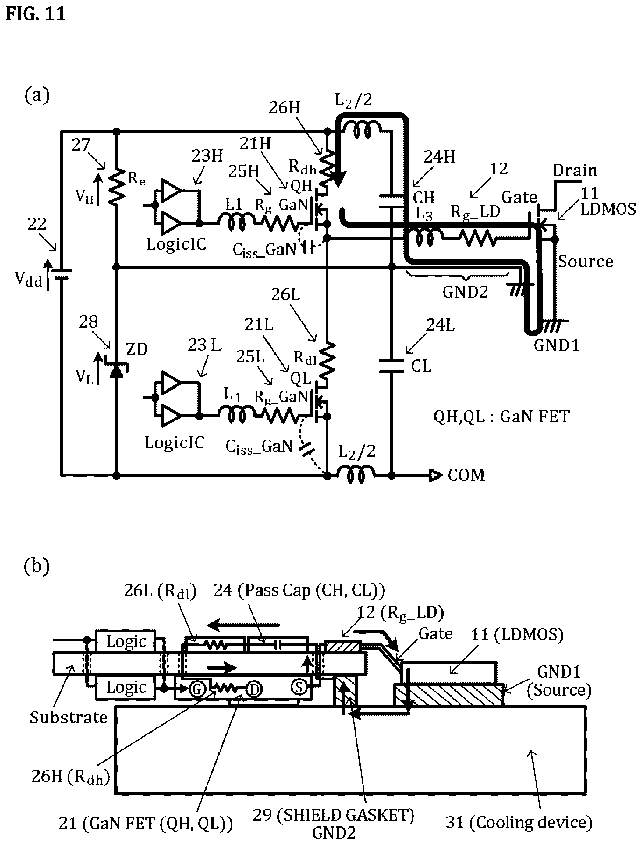

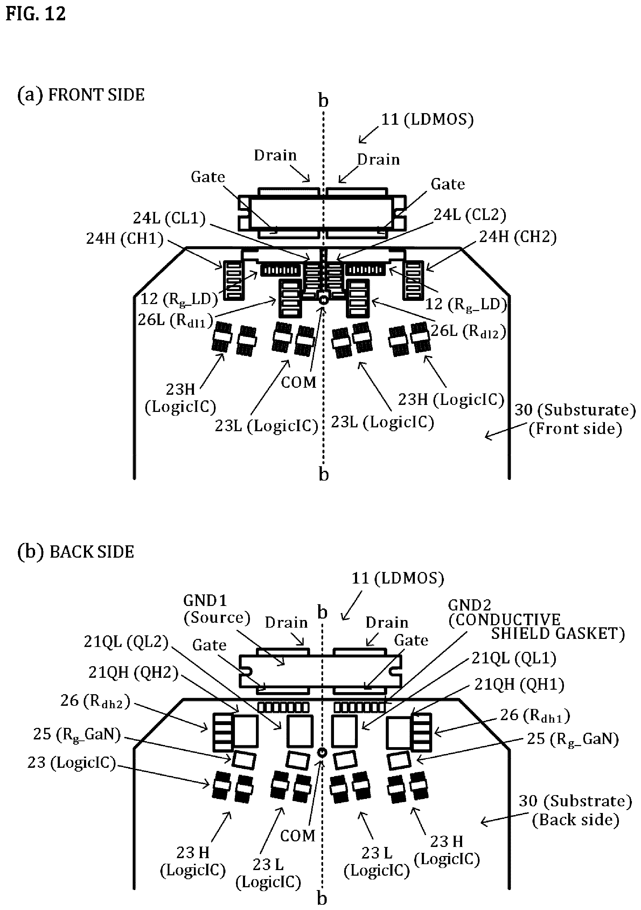

By referring to Figures 8 to 13, arrangement of the circuit elements of the radio-frequency power supply device of the present invention will be described. FIG. 8 shows a planar arrangement, FIG. 9 shows a cross sectional arrangement along a dashed line a-a shown in FIG. 8, and FIG. 10 shows an oblique perspective view of a part of the radio-frequency power supply device. FIG. 11 shows a current loop in the arrangement of the circuit elements. FIG. 12 shows axisymmetric arrangement and radial arrangement of the circuit elements.

In the arrangement of the circuit elements shown in FIGS. 8 to 13, the source terminals of two amplifying elements of the radio frequency unit are grounded to form a push-pull circuit, and the gate drive unit includes two gate drive circuits for applying gate signals to the gate terminals of the two amplifying elements of the radio-frequency amplification unit.

(a) Axisymmetric arrangement of circuit elements

In Figure 8, the push-pull circuit is formed by the two gate drive circuits 20A, 20B having the same circuit configuration, in which the circuit elements having the same function, which form the gate drive circuits 20A, 20B, are arranged symmetrically with respect to a symmetrical axis passing the COM potential. In FIG. 8, a dashed-dotted line b-b represents an axisymmetric line.

The amplifying element 11 (LDMOS1) of the radio-frequency amplification unit and the gate drive circuit 20A of the gate drive unit are arranged on one side of the axisymmetric line b-b (left in the figure), and the amplifying element 11 (LDMOS2) of the radio-amplification unit and the gate drive circuit 20B of the gate drive unit are arranged on the other side of the axisymmetric line b-b (right in the figure).

In the gate drive circuit 20A on the one side of the axisymmetric line b-b (left in the figure), the bypass capacitors 24 (CH1) and 24 (CL1) as well as the drain resistance 26L ($R_{dl1}$) are arranged on the front side of the substrate 30, and furthermore the gate resistance 12 ($R_g\_LD$) is arranged that is connected to the gate terminal of the amplifying element 11 (LDMOS1).

On the back side of the substrate 30, the switching elements 21 (QH1) and 21 (QL1) as well as the drain resistance 26H ($R_{dh1}$) are arranged, and the conductive shield gasket 29 is arranged below the gate resistance 12 ($R_g\_LD$).

In the gate drive circuit 20B on the other side of the axisymmetric line b-b (right in the figure), the bypass capacitors 24 (CH2) and 24 (CL2) as well as the drain resistance 26L ($R_{dl2}$) are arranged on the front side of the substrate 30, and furthermore the gate resistance 12 ($R_g\_LD$) is arranged that is connected to the gate terminal of the amplifying element 11 (LDMOS2).

On the back side of the substrate 30, the switching elements 21 (QH2) and 21 (QL2) as well as the drain resistance 26H ($R_{dh2}$) are arranged, and the conductive shield gasket 29 is arranged below the gate resistance 12 ($R_g$_LD).

In the circuit elements forming the gate drive circuit 20A and the circuit elements forming the gate drive circuit 20B, the circuit elements having the same function are arranged equidistant from each other with respect to the axisymmetric line b-b so as to be arranged with line symmetry.

By arranging spatially line symmetry with the axisymmetric line indicated by the dashed-dotted line b-b, the circuit elements of the two gate drive circuits are arranged electrically symmetrical with the COM potential as a reference potential. Furthermore, the circuit elements are arranged electrically symmetrical to prevent a difference between the two gate signals caused by the deviation of the gate signals from the reference potential, such as deviations in the dead times DT and the pulse widths $T_{on}$ of the gate signals, synchronization deviations of both gate signals.

(b) Front-side and back-side arrangement of circuit elements

Figure 9 schematically shows a cross section at a dashed line a-a in FIG. 8.

In the radio-frequency amplification unit, the gate terminal of the amplifying element 11 (LDMOS) is arranged to be connected to the gate resistance 12 ($R_g$_LD), and the source terminal is arranged to contact with the cooling device 31 as the ground potential (GND1) of the radio-frequency amplification unit.

In the gate drive unit, the conductive shield gasket 29 provided on the back side of the substrate 30 is arranged to contact with the cooling device 31 as the ground potential (GND2) of the gate drive unit. In addition to that, the switching elements 21 (GaNFETs (QH, QL)) provided on the back side of the substrate 30 are arranged to contact with the cooling device 31 via a thermal conductive member, such as a thermal conductive silicone rubber. The cooling device 31 is a conductive metallic member having heat dissipation function, such as a water-cooled plate or fin, and has conductivity to electrically connect the ground potential (GND1) with the ground potential (GND2).

The bypass capacitors 24 (CH, CL) and the drain resistances 26 ($R_{dh}$, $R_{dl}$) as well as the switching elements 21 (QH, QL) are arranged approximately above and below the substrate 30, respectively.

Figure 10 shows the oblique perspective view of a part of the radio-frequency power supply device. The bypass capacitor 24 (CH1) and the gate resistance 12 ($R_g$_LD) are arranged on the front side of the substrate 30, and the switching element 21 (GaNFET (QH1)) and the gate resistant 25 ($R_g$_GaN) connected to the switching element 21 (GaNFET (QH1)) are arranged at a lower position on the back side of the substrate. The switching element 21 (GaNFET (QH1)) is connected with the drive logic IC 23 via the gate resistance 25 (Rg_GaN). The drive logic IC 23 is arranged on the back side of the substrate 30, and may also be arranged on the front side with the substrate in between. Two drive logic ICs 23 are arranged on the front side and the back side with the substrate 30 shown with a dashed line so as to increase the current to be supplied to the switching element 21 (GaNFET (QH1)).

The bypass capacitor 24 (CH1) arranged on the front side and the conductive shield gasket 29 arranged on the back side with the substrate 30 in between can be connected to each other via a through-hole formed in the substrate 30. In addition to that, the drain resistance 26 ($R_{dh1}$) arranged on the back side and the switching element 21 (GaNFET (QH1)) arranged on the back side are connected via the through-hole in the substrate 30 to the bypass capacitor 24 (CH1) arranged on the front side with the substrate 30 in between.

(c) Cooling of circuit elements

In the gate drive unit, the bypass capacitor 24 and a passive element of a resistive element of the gate resistance 12 are arranged on the front side of the substrate 30 and cooled by air. On the other hand, active elements of the switching elements 21 (GaNFET (QH, QL)) are arranged on the back side of the substrate 30 and cooled by the cooling device 31 with which the active elements come into contact via a conductive heat member.

An active element and a passive element, which have different heating value, are arranged on opposite sides via the substrate, and the passive element having the small heating value is arranged on the front side of the substrate to enable the cooling by air. The active element having the large heating value is arranged on the back side of the substrate so as to be forcibly cooled by the cooling device. The cooling device can be a water-cooled plate or fin.

(d) Thermal conduction in circuit elements

In the gate drive unit, the passive elements of the bypass capacitor 24 and the resistive elements are configured such that the number of parallel-connected elements and their effective widths are equal to or wider than widths of the bodies of the amplifying elements of the radio-frequency amplification unit.

The effective widths of the thermal conduction of the passive elements depend on the number of parallel-connected passive elements and their widths of the mounted wiring patterns. The effective widths of the passive elements are made to be equal to or wider than widths of the bodies of the amplifying elements of the radio-frequency amplification unit so that mutual thermal conductivity is enhanced and thermal inequality is eliminated. Furthermore, the wide effective widths of the passive elements contribute to the reduction of the wiring inductance.

(e) Current loop of drive current

A current loop of a drive current is formed between the gate drive unit and the radio-frequency amplification unit. FIG. 11 illustrates the current loop of the drive current, in which FIG. 11(a) shows a current loop by using the circuit diagram shown in FIG. 4, and FIG. 11(b) shows a current loop by using the cross-sectional view shown in FIG. 9.

In the current loop of the drive current in which the high-side switching element 21H (QH) is ON, a gate current for driving the gate of the amplifying element 11 (LDMOS) is applied from the source terminal of the switching element 21H (QH) to the gate terminal of the amplifying element 11 (LDMOS) through the gate resistance 12 ($R_g$_LD).

The drive current flows, as shown in FIG. 11(a), from the source terminal of the amplifying element 11 (LDMOS) to the ground potential (GND1) on the radio-frequency amplification unit side and the ground potential (GND2) on the gate drive unit side and further to the bypass capacitor 24H (CH) and the drain resistance 26H ($R_{dh}$), and returns to the drain terminal of the switching element 21H (QH).

In Figure 11(b), the current from the source terminal of the switching element 21 (QH) arranged on the back side of the substrate 30 flows via the through-hole in the substrate 30 to the gate resistance 12 ($R_g$_LD) arranged on the front side of the substrate 30, and flows into the gate terminal of the amplifying element 11 (LDMOS) to thereby drive the amplifying element 11 (LDMOS). Since the source terminal of the amplifying element 11 (LDMOS) is the ground potential (GND1), the current flows through the cooling device 31 to the conductive shield gasket 29 that is the ground potential (GND2) on the gate drive unit side. The current then flows from the conductive shield gasket 29 to the bypass capacitor 24 (CH) via the through-hole in the substrate 30, and then returns via the through-hole in the substrate 30 to the drain terminal of the switching element 21 (QH) arranged on the back side of the substrate 30 via the drain resistance 26H ($R_{dh}$).

In the gate drive unit, the conductive shield gasket 29 is arranged on the back side of the substrate directly below the gate resistance 12 ($R_g$_LD) arranged on the front layer with the substrate in between. The conductive shield gasket 29 is the ground potential (GND2) on the gate drive unit side. In the radio-frequency amplification unit, the source voltage of the amplifying element is the ground potential (GND1) on the radio-frequency amplification unit side. The ground potential (GND2) on the gate drive unit side is electrically connected to the ground potential (GND1) on the radio-frequency amplification unit side through the cooling device so that the current loop is formed between the gate drive unit and the radio-frequency amplification unit.

In the gate drive unit, the switching element 21 is arranged below the drain resistance 26 ($R_d$) and the bypass capacitor 24 with the substrate 30 in between, and is electrically connected to them via the through-hole provided in the substrate 30. With this arrangement, the circuit elements, such as the switching element 21, the drain resistance 26 ($R_d$), and the bypass capacitor 24, can be arranged closely. It can shorten an electric length of the current loop, thereby reducing the wiring inductance to a small value.

In regard to the electric length of the current loop, the diameter of the current loop viewed from the cross-sectional direction is set to be about 10 [mm] or less, so that the rectangular gate signal can be transmitted with less attenuation due to the wiring inductance.

(g) Linear and radial arrangement of circuit elements

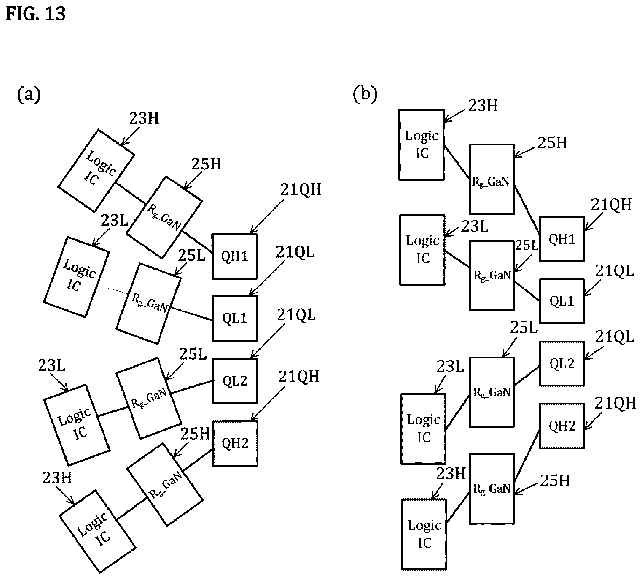

The circuit elements of the radio-frequency power supply device of the present invention are arranged in a line symmetrical manner and also arranged radially. FIGS. 12 and 13 illustrate the radial arrangements.

Figure 12(a) shows the circuit elements arranged on the front side of the substrate 30, and FIG. 12(b) shows the circuit elements arranged on the back side of the substrate 30.

Each of the circuit elements is arranged symmetry with the symmetrical line b-b on the front side and the back side of the substrate 30 while the drive logic IC 23 and the gate resistance 25 are arranged linearly, and the series circuit is arranged radially. The drive logic IC 23 arranged on the back side of the substrate 30 forms the series circuit together with the gate resistance 25 which is connected to the drive logic IC 23, in which series circuit both of the circuit elements are arranged linearly and radially. The circuit elements in the drive logic IC 23 arranged on the front side of the substrate 30 are also arranged radially.

For example, the drive logic IC 23H for driving the switching element 21 (QH1) and the gate resistance 25 are arranged linearly with respect to the switching element 21 (QH1). In regard to the series circuit consisting of the drive logic IC 23L for driving the switching element 21 (QL1) and the gate resistance 25, both of the circuit elements are also arranged linearly. Then, each of these series circuits is arranged radially.

The other series circuits are arranged in the same manner, and thus with respect to the gate terminals of the high-side switching element and the low-side switching element included in the gate drive circuits 20A, 20B, the series circuit consisting of the drive logic IC for applying the drive signal to each gate terminal and the gate resistance 25 ($R_g$_GaN) is arranged linearly and radially. By arranging the series circuit linearly and radially, the electric length of each series circuit and the electric length between the series circuit and the gate terminal of the switching element are respectively equalized, thereby preventing the difference in the wiring inductances caused by the difference in the wiring length, the deviation of the delay time, and the like.

Figure 13(a) schematically shows a configuration in which a series circuit is in the radial arrangement, in which circuit the drive logic IC and the gate resist ($R_g$_GaN) are arranged linearly.

A series circuit consisting of the drive logic IC 23H and the gate resistance 25H ($R_g$_GaN) is arranged linearly and radially.

Correspondingly, a series circuit consisting of the drive logic IC 23L and the gate resistance 25L ($R_g$_GaN) is also arranged linearly with respect to the gate terminal of the switching element and is also arranged radially. This arrangement is also applied to both the gate drive circuit 20A and the gate drive circuit 20B that are arranged in the line symmetrical manner.

Figure 13(b) shows that the drive logic IC 23 and the gate resistance 25 ($R_g$_GaN) are arranged nonlinearly. In this arrangement, the length of the wiring connecting the drive logic IC 23 and the gate resistance 25 ($R_g$_GaN) and the length of the wiring connecting the gate resistance 25 ($R_g$_GaN) and the gate terminal of the switching element 21 are respectively different in the arrangement with respect to each switching element 21, so that the electric lengths are different. The difference in the electric lengths is a factor for the difference in the wiring inductances and the deviation of delay time. In a case where the lengths of the wiring and the electric lengths are respectively equal to each other in the nonlinear manner, the nonlinear arrangement can be employed.

The present invention enables a switching mode operation (class-D to class-F) of the radio-frequency amplifier using the LDMOSFETs, so that the dead time DT and the gate pulse width $T_{on}$ of the gate voltage $V_{gs}$ to be applied to the gate of each amplifying element can be varied, and thereby the PWM control can be conducted at the high-frequency band from 27 [MHz] to 100 [MHz]. Furthermore, since the gate of each amplifying element (LDMOSFET) is always reverse biased when the amplifying element (LDMOSFET) is OFF, the occurrence of the anomalous oscillation can be prevented.

The descriptions about the embodiments and the variations provide some examples of the broad-band RF power supply according to the present invention, and the present invention is not limited to these embodiments. Thus, the present invention can be varied in many ways based on the gist of the invention, and such variations are not excluded from the scope of the invention.

[INDUSTRIAL APPLICABILITY]

The radio-frequency power supply device of the present invention can be applied for industrial purposes, e.g. in a semiconductor manufacturing device having output power of 1 kW or more and a frequency range from 27 [MHz] to 100 [MHz], a flat panel display manufacturing device using liquid crystal or organic EL, and a $CO_2$ laser machine.

[REFERENCE SIGNS LIST]

| | |
|---|---|
| 1 | Radio-Frequency Power Supply Device |
| 10 | Radio-Frequency Amplification Unit |
| 11 | Amplifying Element |
| 12 | Gate Resistance |
| 13 | Gate Protection Circuit |
| 20 | Gate Drive Unit |
| 20A, 20B | Gate Drive Circuit |
| 21 | Switching Element |
| 22 | DC Power Source |
| 23 | Drive Logic IC |
| 24 | Bypass Capacitor |
| 25 | Gate Resistance |
| 26 | Drain Resistance |
| 27 | Series Resistance |
| 28 | Zener Diode |
| 29 | Shield Gasket |
| 30 | Substrate |
| 31 | Cooling Device |
| 100 | Radio-Frequency Power Supply Device |
| 110 | Radio-Frequency Amplification Unit |
| 111 | Amplifying Element |
| 120 | Gate Drive Unit |
| C | Parasitic Capacitance |
| $C_o$ | Capacitance |
| $C_{iss}$ | Gate Capacitance (Input Parasitic Capacitance) |
| $C_{oss}$ | Output Parasitic Capacitance |
| DT | Dead Time |
| $I_g$ | Gate Current |
| L | Wiring Inductance |
| $L_1, L_2, L_3$ | Wiring Inductance |
| LC1, LC2, LC3 | LC Resonance Circuit |
| $L_o$ | Inductance |
| $M_g$ | Mutual Inductance |
| $Q_g$ | Total Gate Charge (Total Gate Charge Amount) |
| $T_{on}$ | Pulse Width |
| $V_H$ | Drive Voltage |
| $V_L$ | Reverse Bias Voltage |
| Vac | AC Voltage |
| $V_{bias}$ | DC Bias Voltage |
| $V_{dc}$ | DC Voltage |
| $V_{dd}$ | Power Source Voltage |
| $V_{gs}$ | Gate Voltage |
| $V_{in}$ | Input Voltage |
| $V_{th}$ | Threshold Voltage |
| b-b | Symmetrical Line |
| $f_{o1}$ | Resonance Frequency |

$f_{o2}$     Resonance Frequency
$f_{o3}$     Resonance Frequency
$f_{sw}$     Switching Frequency
$t_d$     Delay Time
$t_{on}$     Turn-On Time
$t_{sw}$     Time Width

**Claims**

1. A radio-frequency power supply device, comprising:

   a radio-frequency amplification unit that amplifies a high frequency by a switching operation of an amplifying element to put out radio-frequency output power; and
   a gate drive unit that inputs a gate signal to a gate terminal of the amplifying element by a switching operation of a switching element to drive the amplifying element by the gate signal,
   wherein the amplifying element in the radio-frequency amplification unit is a LDMOSFET, and the switching element in the gate drive unit is a GaNFET and conducts PWM control on the radio-frequency amplification unit using the gate signal being a rectangular signal.

2. The radio-frequency power supply device according to claim 1, wherein in the gate drive unit, a drain resistance ($R_d$) configured to attenuate vibration of LC resonance between an output parasitic capacitance ($C_{oss\_}GaN$) of the switching element and a wiring inductance connected to a drain terminal of the switching element is connected to the drain terminal of the switching element.

3. The radio-frequency power supply device according to claim 1 or 2, wherein in the gate drive unit, a total gate charge ($Q_g$) of the switching element is equal to or lower than a total charge amount that is an amount of a gate current ($I_g$) in the switching element injected into the gate terminal within a period of one cycle ($1/f_{sw}$) corresponding to a switching frequency ($f_{sw}$) of the switching operation at radio frequencies.

4. The radio-frequency power supply device according to claim 1 or 2, wherein in the gate drive unit, a wiring inductance ($L_1$) between the switching element and a drive logic IC that applies a drive signal to the gate terminal of the switching element is limited to a value that causes a resonance frequency ($f_{o1}$) of LC resonance with a gate capacitance ($C_{iss\_}GaN$) of the switching element to be equal to or higher than the switching frequency ($f_{sw}$) of the switching operation at radio frequencies.

5. The radio-frequency power supply device according to claim 1 or 2, wherein in the gate drive unit, a wiring inductance ($L_2$) between the switching element and a bypass capacitor that is connected to the drain terminal of the switching element is limited to a value that causes a resonance frequency ($f_{o2}$) of LC resonance with the output parasitic capacitance ($C_{oss\_}GaN$) of the switching element to be equal to or higher than the switching frequency ($f_{sw}$) of the switching operation at radio frequencies.

6. The radio-frequency power supply device according to claim 1 or 2, wherein in the gate drive unit and the radio-frequency amplification unit, a wiring inductance ($L_3$) between a source terminal of the switching element on a high side and the gate terminal of the amplifying element is limited to a value that causes a resonance frequency ($f_{o3}$) of LC resonance with a gate capacitance ($C_{iss\_}LD$) of the amplifying element to be equal to or higher than the switching frequency ($f_{sw}$) of the switching operation at radio-frequencies.

7. The radio-frequency power supply device according to claim 6, wherein a gate resistance ($R_{g\_}LD$) is connected between the source terminal of the switching element on the high side and the gate terminal of the amplifying element, and
   the gate resistance ($R_{g\_}LD$) attenuates LC resonance between the gate capacitance ($C_{iss\_}LD$) of the amplifying element and the wiring inductance ($L_3$) between the source terminal of the switching element on the high side and the gate terminal of the amplifying element.

8. The radio-frequency power supply device according to claim 1 or 2, wherein the radio-frequency amplification unit is a push-pull circuit that connects source terminals of two amplifying elements to ground, and

   the gate drive unit comprises two gate drive circuits that apply gate signals to the gate terminals of the two amplifying elements, wherein the two gate drive circuits are electrically symmetric with each other based on a COM potential, and circuit elements that form each gate drive circuit are arranged in a line symmetrical manner with respect to a symmetrical axis passing through the COM potential.

9. The radio-frequency power supply device according to claim 8, wherein each of gate terminals of a switching element on a high side and a switching element on a low side included in each gate drive circuit is provided with a gate resistance ($R_{g\_}GaN$) connected between each gate terminal and a drive logic IC that applies a drive signal to the gate terminal, and

   has a plurality of DC circuits consisting of the drive logic IC and the gate resistance ($R_{g\_}GaN$)

that are arranged linearly,

the plurality of DC circuits being arranged radially, in which electric lengths of the DC circuits are equal to one another.

10. The radio-frequency power supply device according to claim 1 or 2, wherein the gate drive unit comprises active elements and passive elements,

the passive elements being arranged on a surface layer of a substrate and are cooled by air, the active elements being arranged on a back side of the substrate and are cooled by a cooling device that is in contact with the active elements via a conductive heat member.

11. The radio-frequency power supply device according to claim 10, wherein the cooling device is a water-cooled plate or fin.

12. The radio-frequency power supply device according to claim 1 or 2, wherein the gate drive unit comprises active elements and passive elements, wherein a number of parallel-connected passive elements and their widths of mounted wiring patterns in terms of their effective widths are equal to or wider than widths of bodies of amplifying elements of the radio-frequency amplification unit.

13. The radio-frequency power supply device according to claim 7, wherein in the gate drive unit, a conductive shield gasket is arranged on the back side of the substrate directly below the gate resistance ($R_g$_LD) arranged on the front layer with the substrate in between and is a ground potential on the gate drive unit side, and

in the radio-frequency amplification unit, a source voltage of the amplifying element is a ground potential on the radio-frequency amplification unit side,
the ground potential on the gate drive unit side being electrically connected to the ground potential on the radio-frequency amplification unit side through the cooling device, thereby forming a current loop between the gate drive unit and the radio-frequency amplification unit.

14. The radio-frequency power supply device according to claim 13, wherein in the gate drive unit, the switching element is arranged below the drain resistance ($R_d$) connected to the drain element of the switching element and the bypass capacitor connected to the drain resistance ($R_d$) with the substrate in between and is electrically connected to them via a through-hole formed in the substrate.

15. The radio-frequency power supply device according to claim 13, wherein a loop diameter of a path of the current loop is 10 [mm] or less.

16. The radio-frequency power supply device according to claim 14, wherein a loop diameter of a path of the current loop is 10 [mm] or less.

17. The radio-frequency power supply device according to claim 1 or 2, wherein the gate drive unit comprises a switching element on a high side and a switching element on a low side, which are connected in series to each other; and

a series circuit that consists of a series resistance ($R_e$) and a Zener diode (ZD) and is connected in parallel to a DC power source, wherein a voltage across the DC resistance ($R_e$) is applied as a drive voltage ($V_H$) to the high-side switching element, and
a voltage across the Zener diode (ZD) is applied as a reverse bias voltage ($V_L$) to the low-side switching element, and
the radio-frequency amplification unit is equipped with a gate protection circuit that protects a gate of the amplifying element, wherein the drive voltage ($V_H$) and the reverse bias voltage ($V_L$) are within a range of a rated voltage of the gate protection circuit,
the high-side switching element has its drain terminal connected with a drain resistance ($R_{dh}$), and
the low-side switching element has its drain terminal connected with a drain resistance ($R_{dl}$).

FIG. 1

**FIG. 2**

**FIG. 3**

FIG. 4

FIG. 5

FIG. 6

(a)

13

Drain

LDMOS

Gate

Q1

M1

Q2

M2

Source

ESD protection

(b)

$V_{bias}$

$V_{ac}$

RANGE OF
PROTECTION
VOLTAGE

EXCESSIVE VOLTAGE

FIG. 7

(a) Rd not provided

(b) Rd provided

**FIG. 8**

QH1, QL1, QH2, QL2 : GaN FET

**FIG. 9**

FIG. 10

**FIG. 11**

(a)

(b)

# FIG. 12

## (a) FRONT SIDE

b

11 (LDMOS)

Drain    Drain

Gate                          Gate

24L (CL1)                          24L (CL2)

24H (CH1)                          24H (CH2)

12 ($R_{g\_LD}$)                          12 ($R_{g\_LD}$)

26L ($R_{dl1}$)                          26L ($R_{dl2}$)

23H
(LogicIC)          COM          23H (LogicIC)

23L (LogicIC)    23L (LogicIC)          30 (Substurate)
(Front side)

b

## (b) BACK SIDE

11 (LDMOS)

GND1
(Source)   Drain   b   Drain           GND2
Gate           Gate          (CONDUCTIVE
SHIELD GASKET)

21QL (QL2)                          21QL (QL1)

21QH (QH2)                          21QH (QH1)

26 ($R_{dh2}$)                          26 ($R_{dh1}$)

25 ($R_{g\_GaN}$)                          25 ($R_{g\_GaN}$)

23 (LogicIC)

COM

23 H                23 L          23 L          23 H
(LogicIC)      (LogicIC)    (LogicIC)    (LogicIC)
(LogicIC)

30 (Substrate)
(Back side)

b

FIG. 13

(a)

(b)

## FIG. 14

## INTERNATIONAL SEARCH REPORT

| International application No. |
| --- |
| **PCT/JP2023/008248** |

| A. | CLASSIFICATION OF SUBJECT MATTER |
| --- | --- |

*H02M 7/48*(2007.01)i; *H02M 1/08*(2006.01)i; *H03F 3/217*(2006.01)i; *H03K 17/687*(2006.01)i; *H05H 1/46*(2006.01)i
FI: H02M7/48 F; H03F3/217 130; H02M1/08 A; H03K17/687 F; H05H1/46 R

According to International Patent Classification (IPC) or to both national classification and IPC

| B. | FIELDS SEARCHED |
| --- | --- |

Minimum documentation searched (classification system followed by classification symbols)

H02M7/48; H02M1/08; H03F3/217; H03K17/687; H05H1/46

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 7068540 B1 (KYOSAN ELECTRIC MFG. CO., LTD.) 16 May 2022 (2022-05-16) paragraphs [0138], [0139], [0157]-[0161], fig. 5, 8 | 1, 3, 4, 6, 7 |
| A | | 2, 5, 8-17 |
| Y | JP 2021-535702 A (EFFICIENT POWER CONVERSION CORP.) 16 December 2021 (2021-12-16) paragraphs [0002]-[0009], fig. 1, 2 | 1, 3, 4, 6, 7 |
| A | | 2, 5, 8-17 |
| A | JP 2022-81242 A (KYOSAN ELECTRIC MFG. CO., LTD.) 31 May 2022 (2022-05-31) paragraphs [0001]-[0003], [0015]-[0031], fig. 1-3 | 1-17 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **12 May 2023** | **23 May 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
**Information on patent family members**

International application No.

**PCT/JP2023/008248**

| Patent document cited in search report | | | Publication date (day/month/year) | Patent family member(s) | | | Publication date (day/month/year) |
|---|---|---|---|---|---|---|---|
| JP | 7068540 | B1 | 16 May 2022 | (Family: none) | | | |
| JP | 2021-535702 | A | 16 December 2021 | US | 2020/0076426 | A1 | |
| | | | | paragraphs [0008], [0009], fig. 2A | | | |
| | | | | WO | 2020/047119 | A1 | |
| | | | | KR | 10-2021-0072762 | A | |
| | | | | CN | 112889220 | A | |
| JP | 2022-81242 | A | 31 May 2022 | WO | 2022/107375 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017092915 A
- JP H08140341 A